(19) Europäisches Patentamt European Patent Office Office européen des brevets

(11) **EP 4 191 266 B1**

(12) **EUROPEAN PATENT SPECIFICATION**

(45) Date of publication and mention
of the grant of the patent:
**13.08.2025 Bulletin 2025/33**

(21) Application number: **22209938.4**

(22) Date of filing: **28.11.2022**

(51) International Patent Classification (IPC):
***G01R 31/52*** *(2020.01)*

(52) Cooperative Patent Classification (CPC):
**G01R 31/52**

(54) **ELECTRIC LEAKAGE DETECTION METHOD**

VERFAHREN ZUR ERKENNUNG ELEKTRISCHER LECKSTRÖME

PROCÉDÉ DE DÉTECTION DE FUITE ÉLECTRIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **01.12.2021 JP 2021195291**

(43) Date of publication of application:
**07.06.2023 Bulletin 2023/23**

(73) Proprietor: **Prime Planet Energy & Solutions, Inc.
Chuo-ku
Tokyo
103-0022 (JP)**

(72) Inventors:
• **FURUKAWA, Kimihiko
Tokyo, 103-0022 (JP)**
• **YANO, Junya
Tokyo, 103-0022 (JP)**

(74) Representative: **Kuhnen & Wacker
Patent- und Rechtsanwaltsbüro PartG mbB
Prinz-Ludwig-Straße 40A
85354 Freising (DE)**

(56) References cited:
**WO-A1-2020/170556     US-A1- 2016 091 551**

**Description**

BACKGROUND

1. Technical Field

The present disclosure relates to an electric leakage detection method. Specifically, the present disclosure relates to an electric leakage detection method of detecting an electric leakage occurring position in an electricity distribution system where a power source unit and an electric device are electrically connected to each other, as disclosed, for example, in US 2016/091551 A1.

2. Description of the Related Art

A power source unit including a power source such as a secondary battery and a power generation element is used in a variety of electric devices. For example, an electric vehicle uses, as a power source unit, an assembled battery including multiple secondary batteries, and an electricity distribution system is constructed in which electric power is supplied to a motor (electric device) from the power source unit. This electricity distribution system is usually insulated from the ground for safety reason. However, depending on the conditions of use, electric leakage may occur between a portion of the electricity distribution system and the ground due to failure of parts or contamination by foreign matter (e.g., moisture and metal pieces). In such a case, it is required to determine the electric leakage occurring position in an early stage and perform repairing such as replacing parts or removing foreign substances. Thus, an electric leakage detection technology of detecting an electric leakage in an electricity distribution system by measuring an electric resistance of an insulating portion.

For example, JP 2007-327856 discloses an electric leakage detection circuit for electric vehicles. In JP 2007-327856, an assembled battery (power source unit) including multiple secondary batteries (power sources) is an inspection target. The electric leakage detection circuit includes: a first electric leakage detection switch connected to a high voltage side of the assembled battery; a second electric leakage detection switch connected to a low voltage side; a control circuit configured to alternately switch on and off of the first electric leakage detection switch and the second electric leakage detection switch; an electric leakage detection resistor connected to the assembled battery via the first electric leakage detection switch and the second electric leakage detection switch and connected to ground at its midpoint; a voltage detection circuit configured to detect electric leakage voltages on the high voltage side and the low voltage side of the electric leakage detection resistor from the ground; and an arithmetic circuit configured to calculate an output of the voltage detection circuit and detect an electric leakage. The electric leakage detection circuit detects a first electric leakage voltage with the first electric leakage detection switch on and the second electric leakage detection switch off. The electric leakage detection circuit detects a second electric leakage voltage with the first electric leakage detection switch OFF and the second electric leakage detection switch ON. The arithmetic circuit of the electric leakage detection circuit detects an electric leakage resistance in the assembled battery based on the first electric leakage voltage, the second electric leakage voltage, and a total voltage of the assembled battery.

JP 2007-149561 and WO 2020/170556 A1disclose other examples of electric leakage detection circuits. In JP 2007-149561, the assembled battery is an inspection target. The electric leakage detection circuit includes multiple circuit blocks, a resistance voltage detection circuit, a control circuit, and an electric leakage determination circuit. The circuit blocks are connected to connection points between multiple battery units and connect the connection points to the ground via a measurement resistor and a series circuit of a switching element. The resistance voltage detection circuit detects measurement resistance voltages of the circuit blocks. The control circuit controls the switching element of each circuit block. The electric leakage determination circuit detects an electric leakage based on the detected voltages of the resistance voltage detection circuit. In the electric leakage detection circuit with such a configuration, switching elements of the circuit blocks are sequentially switched ON/OFF, and detects a circuit block for which a voltage at a measurement resistance is detected by the resistance voltage detection circuit. This allows the battery unit with an electric leakage occurring to be determined.

SUMMARY

The electric leakage detection technology described above can detect an electric leakage occurred in the power source unit (assembled battery). However, in the electricity distribution system where the power source unit and the electric device are connected to each other, an electric leakage may occur in an electric device-side region. For example, the electric leakage resistance detected by the electric leakage detection technology described in JP 2007-327856 is not influenced by the electric leakage occurring position. Thus, it is difficult to determine which region near the power source unit or near the electric device is causing the electric leakage. The electric leakage detection technology described in JP 2007-149561 requires many circuit blocks to be provided. This causes the electric leakage detection circuit to be more complex and expensive.

The present disclosure was made to solve the problems, and intended to provide a technology capable of determining an electric leakage occurring position in the electricity distribution system where a power source unit and an electric device are electrically connected to each other, at low cost and in a simplified manner.

In order to achieve the objective, an electric leakage detection method disclosed in claim 1 is provided. Preferred embodiments of the method are disclosed in claims 2 to 6.

The electric leakage detection method disclosed herein detects an electric leakage occurring position in an electricity distribution system where a power source unit and an electric device are electrically connected to each other. The electricity distribution system to which the electric leakage detection method is applied includes: a positive electrode electroconductive path which connects between a positive electrode of a power source unit and an electric device; a negative electrode electroconductive path which connects between a negative electrode of the power source unit and an electric device; a positive-side contactor attached to the positive electrode electroconductive path and configured to switch ON/OFF of connection between the power source unit and the electric device; and a negative-side contactor attached to the negative electrode electroconductive path and configured to switch ON/OFF of connection between the power source unit and the electric device. The electric leakage detection method disclosed herein includes: first detection of turning at least one of the positive-side contactor or the negative-side contactor ON and detecting a value of a system electric leakage resistance $R_Z$ which is an electric leakage resistance of the entire electricity distribution system; second detection of turning both of the positive-side contactor and the negative-side contactor OFF and detecting a value of a power source-side electric leakage resistance $R_L$ which is a power source unit-side electric leakage resistance; and first determination of determining which of the power source unit-side region or the electric device-side region is causing the electric leakage based on the values of the system electric leakage resistance $R_Z$ and power source-side electric leakage resistance $R_L$.

In the electric leakage detection method with such a configuration, the value of the system electric leakage resistance $R_Z$ is detected with the power source unit and the electric device connected to each other, and the value of the power source-side electric leakage resistance $R_L$ with the power source unit and the electric device connected to each other. If the values of the system electric leakage resistance $R_Z$ and the power source-side electric leakage resistance $R_L$ are approximate, it can be determined that an electric leakage is occurring in the power source unit-side region, which is a target for detection of the value of the power source-side electric leakage resistance $R_L$. If the values of the system electric leakage resistance $R_Z$ and the power source-side electric leakage resistance $R_L$ are significantly different from each other, it can be determined that an electric leakage is occurring in a region (i.e., the electric device-side region) different from the power source unit-side region. In this manner, the technology disclosed herein allows whether the power source unit-side region or the electric device-side region in the electricity distribution system is causing an electric leakage to be determined in a simplified manner by merely detecting values of the system electric leakage resistance $R_Z$ and the power source-side electric leakage resistance $R_L$.

A preferred electric leakage detection method disclosed herein further includes: the first determination includes: entire determination of comparing the value of the system electric leakage resistance $R_Z$ with a first threshold value $D_1$, determining that an electric leakage is not occurring in the entire electricity distribution system if the value of the system electric leakage resistance $R_Z$ is equal to or higher than the first threshold value $D_1$, and determining that an electric leakage is occurring in the electricity distribution system if the value of the system electric leakage resistance $R_Z$ is less than the first threshold value $D_1$; and region determination of comparing the value of the power source-side electric leakage resistance $R_L$ with a second threshold value $D_2$ if it is determined that the electric leakage is occurring in the electricity distribution system in the entire determination, determining that the electric leakage is occurring in the electric device-side region if the value of the power source-side electric leakage resistance $R_L$ is equal to or higher than the second threshold value $D_2$, and determining that the electric leakage is occurring in the power source unit-side region if the power source-side electric leakage resistance $R_L$ is less than the second threshold value $D_2$. As mentioned above, if electric leakage resistances detected are less than the predetermined threshold values, it can be determined that there is a low resistance portion (i.e., an electric leakage is occurring). This allows which of the power source unit-side region or the electric device-side region is causing the electric leakage to be determined appropriately.

A further preferred electric leakage detection method disclosed herein further includes: the first determination includes: calculating an absolute value $|R_Z - R_L|$ of difference between the values of the system electric leakage resistance $R_Z$ and the power source-side electric leakage resistance $R_L$, comparing the absolute value $|R_Z - R_L|$ of the difference with a fourth threshold value $D_4$, determining that an electric leakage is occurring in the electric device-side region if the absolute value $|R_Z - R_L|$ of the difference is equal to or higher than the fourth threshold value $D_4$, and determining that an electric leakage is occurring in a power source unit-side region if the value of the absolute value $|R_Z - R_L|$ of the difference is less than the fourth threshold value $D_4$. In this manner, the calculation of the absolute value $|R_Z - R_L|$ of the difference between the values of the system electric leakage resistance $R_Z$ and the power source-side electric leakage resistance $R_L$ allows determination of whether or not the values of the system electric leakage resistance $R_Z$ and the power source-side electric leakage resistance $R_L$ is approximate in a simplified manner.

The electric leakage detection method of the invention further includes: third detection of calculating a value of a device-side electric leakage resistance $R_V$ which is an electric leakage resistance in the electric device, based on the following equation (1). This makes it easy to determine the degree of the electric leakage occurring in the electric device-side region.

[Math. 1]

$$Rv = \frac{Rz \cdot RL}{RL - Rz} \qquad (1)$$

In the electric leakage detection method of the invention, in the third detection, a value of a first device-side electric leakage resistance $R_{V1}$ which is a device-side electric leakage resistance $R_V$ at rest of the electric device is calculated. The aspect of the electric leakage detection method further includes: second determination of determining which of the electric device or an electric device-side region excluding the electric device is causing the electric leakage based on the value of the first device-side electric leakage resistance $R_{V1}$ if it is determined that the electric leakage is occurring in the electric device-side region in the first determination. The electric leakage detection method with such a configuration allows which portion of the electric device-side region is causing the electric leakage to be determined in more detail if it is determined that the electric leakage is occurring in the electric device-side region.

The electric leakage detection method of the invention further includes: in the second determination, the value of the first device-side electric leakage resistance $R_{V1}$ is compared with a third threshold value $D_3$, it is determined that an electric leakage is occurring in the electric device if the first device-side electric leakage resistance $R_{V1}$ is equal to or higher than the third threshold value $D_3$, and it is determined that an electric leakage is occurring in the electric device-side region excluding the electric device if the value of the first device-side electric leakage resistance $R_{V1}$ is less than the third threshold value $D_3$. This allows which portion of the electric device-side region is causing the electric leakage to be determined in more detail.

The electric leakage detection method of the invention further includes: fourth detection of detecting a value of a positive electrode-side electric leakage resistance $R_{LP}$ which is an electric leakage resistance of a positive electrode electroconductive path and a value of a negative electrode-side electric leakage resistance $R_{LN}$ which is an electric leakage resistance of a negative electrode electroconductive path; and electric leakage occurring position determination of determining an electric leakage occurring position in the electric device-side region excluding the electric device, based on the values of the positive electrode-side electric leakage resistance $R_{LP}$ and the negative electrode-side electric leakage resistance $R_{LN}$ if it is determined that the electric leakage is occurring in the electric device-side region excluding the electric device in the second determination. The electric leakage detection method with such a configuration allows which portion of the electric device-side region excluding the electric device (typically any of the positive electrode electroconductive path, the negative electrode electroconductive path, and a common device) is causing the electric leakage to be determined in more detail.

A further preferred electric leakage detection method disclosed herein further includes: the electricity distribution system includes: a reference electrical potential difference detection unit configured to detect a reference electrical potential difference $V_S$ which is an electrical potential difference between a first terminal connected to a predetermined position of the power source unit and a second terminal connected to a portion with a different electrical potential from the first terminal; and an electric leakage voltage detection unit connected to the first terminal and the second terminal and is connected to ground at its midpoint. The electric leakage voltage detection unit includes a first switch connected to a first terminal side, a first voltage detection resistance provided between the first switch and the midpoint, a second switch connected to a second terminal side, and a second voltage detection resistance provided between the second switch and the midpoint. The circuit with such a configuration allows the values of the electric leakage resistances to be detected in a simplified manner.

A further preferred electric leakage detection method disclosed herein further includes: in the fourth detection, the value of the positive electrode-side electric leakage resistance $R_{LP}$ is calculated based on the following equation (2), and the value of the negative electrode-side electric leakage resistance $R_{LN}$ is calculated based on the equation (3). This allows more accurate determination of the values of the positive electrode-side electric leakage resistance $R_{LP}$ and the negative electrode-side electric leakage resistance $R_{LN}$.

[Math. 2]

$$R_{LP} = \left[ 1 + \frac{V_g(t_1)}{V_g(t_2)} \cdot \frac{V_S(t_2)}{V_S(t_1)} \right] \cdot R_Z \qquad (2)$$

[Math. 3]

$$R_{LN} = \left[ 1 + \frac{V_g(t_2)}{V_g(t_1)} \cdot \frac{V_S(t_1)}{V_S(t_2)} \right] \cdot R_Z \qquad (3)$$

In the equations (2) and (3), "$V_{g(t1)}$" represents a first ground voltage $V_{g(t1)}$ detected by the electric leakage voltage detection unit at a first timing t1 when the first switch is turned ON and the second switch is turned OFF, "$V_S$ (t1)" represents a first reference electrical potential difference $V_S$ (t1) detected by the reference electrical potential difference detection unit at the first timing t1, "Vg (t2)" represents a second ground voltage Vg (t2) detected by the electric leakage voltage detection unit at a second timing t2 when the first switch is turned OFF and the second switch is turned ON, and "$V_S$ (t2)" represents a second reference electrical potential difference $V_S$ (t2) detected at the second timing t2 in the reference electrical potential difference detection unit.

A further preferred electric leakage detection method disclosed herein further includes: the power source unit including multiple power sources. fifth detection of obtaining a reference electrical potential difference $V_S$ which is an electrical potential difference between the first terminal connected to a predetermined position of the power source unit and the second terminal connected to a portion with a different electrical potential from the first terminal if it is determined that an electric leakage is occurring in the power source unit-side region in the first determination; sixth detection of calculating a power source-side electric leakage voltage $V_L$ which is an electrical potential difference between the reference terminal and the electric leakage occurring position with either one of the first terminal or the second terminal as a reference terminal; and seventh detection of detecting a distance from the reference terminal to the electric leakage occurring position based on the ratio ($V_L/V_S$) of the power source-side electric leakage voltage $V_L$ to the reference electrical potential difference $V_S$, and The electric leakage detection method with such a configuration allows which position of the power source unit-side region is causing the electric leakage to be determined in detail if it is determined that the electric leakage is occurring in the power source unit-side region in the first determination.

BRIEF DESCRIPTION OF THE DRAWINGS

[Fig. 1] Fig. 1 is a circuit diagram illustrating an electricity distribution system for performing an electric leakage detection method according to a first embodiment.

[Fig. 2] Fig. 2 is a flowchart illustrating the electric leakage detection method according to the first embodiment.

[Fig. 3] Fig. 3 is a flowchart illustrating an electric leakage detection method according to a third embodiment.

[Fig. 4] Fig. 4 is a flowchart illustrating an electric leakage detection method according to a fourth embodiment.

[Fig. 5] Fig. 5 is a circuit diagram illustrating an electricity distribution system for performing an electric leakage detection method according to a fifth embodiment.

[Fig. 6] Fig. 6 is a circuit diagram illustrating an electricity distribution system for performing an electric leakage detection method according to a sixth embodiment.

DETAILED DESCRIPTION

The following describes embodiments of the technology disclosed herein. The matters necessary for executing the technology disclosed herein, except for matters specifically herein referred to (e.g., the detailed structures of the power source unit and the electric devices and parts used to construct the electricity distribution system) can be grasped as design matters of those skilled in the art based on the related art in the preset field. The technology disclosed herein can be executed based on the contents disclosed herein and the technical knowledge in the present field.

<First Embodiment>

A first embodiment of the electric leakage detection method disclosed herein will be described below.

1. Electricity Distribution System

The electric leakage detection method disclosed herein detects an electric leakage occurring position in an electricity distribution system where a power source unit and an electric device are electrically connected to each other. A "power source unit" herein refers to a device including at least one power source and is constructed to supply electric power from the power source to the electric device. A "power source" herein refers to a device that is capable of supplying (discharging) electric power to at least outside. Examples of the power source include: secondary batteries such as a lithium-ion secondary battery, a nickel hydride battery, and a nickel cadmium battery; primary batteries such as a manganese dry battery and an alkali dry battery; capacitors such as an electric double-layer capacitor; and power generating elements such as a fuel battery and a solar battery.

The "electric device" encompasses all devices which operate by electric power supplied from the power source unit in a non-insulated manner. Although it does not limit the technology disclosed herein, examples of the electric device include vehicle equipment, air-conditioning equipment, housing equipment, cooking appliances, cleaning equipment, and AV equipment. The vehicle equipment includes a propulsion motor for electric vehicles, a car air conditioner, and the like. The air-conditioning equipment includes an air conditioner, an electric fan, an air fan, an air purifier, an electrically heated floor mat, a petroleum fan heater, an electric stove, and the like. The housing equipment includes electric blinds, an electric curtain, a water heater, an electric lock, a smart meter, a general light, a single-function light, an emergency light, and the like. The cooking appliance includes an IH cooking device (cooking heater), a microwave oven, an oven toaster, and the like. The cleaning equipment includes a dishwasher, a dish dryer, a washing machine, a laundry dryer, and the like. The AV equipment includes TV, a display, and the like.

In the following description, multiple secondary batteries (single batteries) are used as "power sources," and an assembled battery where the single batteries are electrically connected to each other is used as a "power source unit." In addition, as an "electric device" which operates by electric power supplied from the power source unit (the assembled battery) in a non-insulated manner, a motor for electric vehicles may also be used. However, the inspection target for the electric leakage detection method disclosed herein is not limited to the electricity distribution system where the assembled battery and the motor are connected to each other. The electric leakage detection method disclosed herein is applicable to the electricity distribution system where various power source units and the electric device are combined without particular limitations.

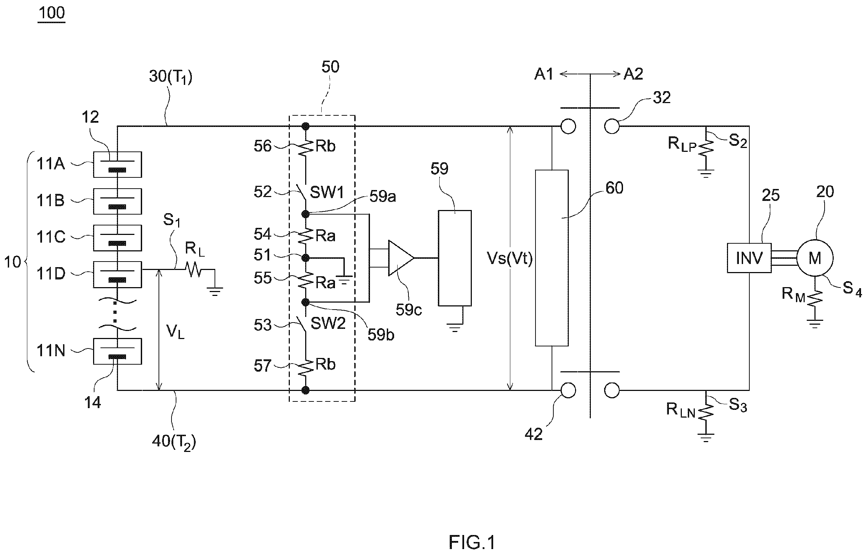

Fig. 1 is a circuit diagram illustrating an electricity distribution system for performing an electric leakage detection method according to a first embodiment. As shown in Fig. 1, the electricity distribution system 100 includes: an assembled battery 10, a motor 20, a positive electrode electroconductive path 30, a negative electrode electroconductive path 40, an electric leakage detection unit 50, and a reference electrical potential difference detection unit 60. Each component will be described below.

(1) Assembled Battery (Power Source Unit)

As mentioned above, an assembled battery 10 is an example of the power source unit. The assembled battery 10 shown in Fig. 1 includes multiple (N) single batteries 11A to 11N. In the assembled battery 10, multiple single batteries 11A to 11N are aligned adjacent to each other along a predetermined alignment direction. The single batteries aligned are electrically connected to each other via connection members. The positive electrode terminal of the first single battery 11A arranged at one end of the assembled battery 10 is not connected to the other single batteries. The positive electrode terminal of the first single battery 11A is a total positive terminal 12 opening to be connectable to a motor 20. The negative electrode terminal of the n-th single battery 11N arranged at the other end of the assembled battery 10 is not connected to the other single batteries. The negative electrode terminal of the n-th single battery 11N is a total minus terminal 14 opening to be connectable to the motor 20. The number of single batteries constituting the assembled battery 10 is not particularly limited and can be changed, as appropriate, according to the performance (e.g., an output voltage, an installation space) required for the assembled battery. For example, the number of single batteries may be 50 or more, 75 or more, 90 or more, or 100 or more. The upper limit of the number of single batteries is not particularly limited, and may be 200 or less, or 150 or less.

(2) Motor (Electric Device)

The motor 20 is an electric device which converts electric power from the assembled battery 10 into power and drives a driving wheel of the electric vehicle. The specific structure of the motor 20 is not particularly limited, and an appropriate structure may be selected according to the applications, among known structures. For example, a three-phase AC synchronous motor obtained by embedding a permanent magnet into a rotor can be used as the motor 20. The three-phase AC synchronous motor is operated by input of AC power, and rotates the driving whole. In the electricity distribution system 100 shown in Fig. 1, an inverter 25 is arranged on the electroconductive path from the assembled battery 10 to the motor 20. This allows DC power supplied from the assembled battery 10 to be converted into AC power and the AC power to be supplied to the motor 20.

(3) Electroconductive Path

As mentioned above, the electricity distribution system 100 is constructed by electrically connecting between the assembled battery 10 (the power source unit) and the motor 20 (the electric device). As shown in Fig. 1, the electricity distribution system 100 includes a positive electrode electroconductive path 30 which connects between the positive electrode of the assembled battery 10 and the motor 20, and a negative electrode electroconductive path 40 which connects between the negative electrode of the assembled battery 10 and the motor 20. Specifically, the positive electrode electroconductive path 30 is connected to the total positive terminal 12 of the first single battery 11A, and to the motor 20 via the inverter 25. The negative electrode electroconductive path 40 is connected to the total negative terminal 14 of the n-th single battery 11N, and to the motor 20 via the inverter 25.

A positive-side contactor 32 which switches ON/OFF of connection between the assembled battery 10 and the motor 20 is attached to the positive electrode electroconductive path 30 in the present embodiment. A negative-side contactor 42 which switches ON/OFF of connection between the assembled battery 10 and the motor 20 is attached to the negative electrode electroconductive path 40. The structure of the connector in the technology disclosed herein is not particularly limited, and a connector which can be used to construct this kind of electric circuit can be used without particular limitations. The positive-side contactor 32 and the negative-side contactor 42 are connected to a control unit (not shown) configured to control operation of the electricity distribution system 100, and configured to be switchable between ON/OFF by a signal from the control unit. For example, as the positive-side contactor 32 and the negative-side contactor 42, a normally open contactor which disconnects between the assembled battery 10 and the motor 20 while no command signal is input and which connects between the assembled battery 10 and the motor 20 when the command signal is input can be used. Another example of the contactor includes normally close contactor which connects between the assembled battery 10 and the motor 20 while no command signal is input from outside, and disconnects between then when the command signal is input. In the specification, a region where the positive-side contactor 32 and the negative-side contactor 42 are boundaries and the assembled battery 10 (the power source unit) is arranged is referred to as the "power source unit-side region A1." In the specification, a region where the positive-side contactor 32 and the negative-side contactor 42 are boundaries and the motor 20 (the power breathing apparatus) is arranged is referred to as the "electric device-side region A2."

(4) Electric Leakage Detection Unit

The electric leakage detection unit 50 is a circuit used to detect various electric leakage resistances to be described later. The electric leakage detection unit 50 is connected to a first terminal $T_1$ connected to the predetermined position of the power source unit 10, and a second terminal $T_2$ connected to a portion with a different electrical potential from the first terminal $T_1$. In the present embodiment, the positive electrode electroconductive path 30 connected to the total positive terminal 12 of the power source unit 10 is regarded as the first terminal $T_1$, and the negative electrode electroconductive path 40 connected to the total negative terminal 14 is regarded as the second terminal $T_2$. In other words, the electric leakage detection unit 50 in the present embodiment is connected between the positive electrode electroconductive path 30 and the negative electrode electroconductive path 40 in the power source unit-side region A1. The electric leakage detection unit 50 is connected to the ground at its midpoint 51. In other words, the midpoint 51 of the electric leakage detection unit 50 is configured to be conducted with the electric leakage occurring position via ground when an electric leakage is occurring in the electricity distribution system 100. The electric leakage detection unit 50 in the present embodiment is configured to detect a first ground voltage $V_{g(t1)}$ which is an electrical potential difference between the positive electrode electroconductive path 30 via the ground and the electric leakage occurring position, and a second ground voltage $V_g (t2)$ which is an electrical potential difference between the negative electrode electroconductive path 40 via the ground and the electric leakage occurring position. Specifically, the electric leakage detection unit 50 is provided with two switching elements including a first switch 52 and a second switch 53; and four resistances including a first voltage detection resistance 54, a second voltage detection resistance 55, a first voltage dividing resistance 56, and a second voltage dividing resistance 57.

The first switch 52 is a switching element connected to a position closer to the first terminal $T_1$ (the positive electrode electroconductive path 30) than to the midpoint 51. The second switch 53 is a switching element connected to a position closer to the second terminal $T_2$ (the negative electrode electroconductive path 40) than to the midpoint 51. The structures of the switching elements are not particularly limited, and a semiconductor switching element such as a transistor and FET or mechanical switch such as a relay can be used. Although not shown in the drawings, the first switch 52 and the second switch 53 are connected to the control unit configured to control operation of the electricity distribution system 100, and configured to be switchable between ON/OFF by a signal from the control unit. Although described in detail later, the control unit of the electricity distribution system 100 controls operation of each switching element such that the second switch 53 is OFF when the first switch 52 is ON, and the first switch 52 is OFF when the second switch 53 is ON.

Next, four resistances of the electric leakage detection unit 50 will be described. The first voltage detection resistance 54 is a resistance provided between the first switch 52 and the midpoint 51. The second voltage detection resistance 55 is a resistance provided between the second switch 53 and the midpoint 51. The first voltage dividing resistance 56 is a resistance provided between the positive electrode electroconductive path 30 and the first switch 52. The second voltage dividing resistance 57 is a resistance provided between the negative electrode electroconductive path 40 and the second switch 53. In the electric leakage detection unit 50 shown in Fig. 1, the first voltage detection resistance 54 and the second voltage detection resistance 55 are set to the same electric resistance Ra. The first voltage dividing resistance 56 and the second voltage dividing resistance 57 are set to the same electric resistance Rb. However, the resistances may have different electric resistances.

Next, the electric leakage detection unit 50 includes a voltage detection unit 59. The voltage detection unit 59 is connected to a first connection point 59a provided between the first switch 52 and a first voltage detection resistance 54, and a second connection point 59b provided between the second switch 53 and a second voltage detection resistance 55. A differential arithmetic circuit 59c is arranged between the first connection point 59a (the second connection point 59b) and the voltage detection unit 59. The voltage detection unit 59 in the present embodiment detects the following four kinds of ground voltages Vg based on the voltages input.

The state where the first switch 52 is ON and the second switch 53 is OFF with the assembled battery 10 and the motor 20 connected to each other by turning either one of the positive-side contactor 32 or the negative-side contactor 42 ON is referred to as a first timing (t1). The ground voltage Vg detected at the first timing (t1) is referred to as a "first ground voltage $V_{g(t1)}$." Next, the state where the first switch 52 is OFF and the second switch 53 is ON with either one of the positive-side contactor 32 or the negative-side contactor 42 ON is referred to as a second timing (t2). The ground voltage Vg detected at the second timing (t2) is referred to as a "second ground voltage Vg (t2)." The state where the first switch 52 is ON and the second switch 53 is OFF with both of the positive-side contactor 32 and the negative-side contactor 42 OFF and the assembled battery 10 and the motor 20 disconnected to each other is referred to as a "third timing (t3)." The ground voltage $V_g$ detected at the third third timing ($t_3$) is referred to as a "third ground voltage Vg ($t_3$)." Next, the state where the first switch 52 is OFF and the second switch 53 is ON with both of the positive-side contactor 32 or the negative-side contactor 42 OFF is referred to as a fourth timing ($t_4$). The ground voltage $V_g$ detected at the fourth timing ($t_4$) is referred to as a "fourth ground voltage $V_g$ ($t_4$)."

In the electric leakage detection unit 50, the first ground voltage $V_{g(t1)}$ divided by the first voltage dividing resistance 56 and the first voltage detection resistance 54 is input to the voltage detection unit 59. Similarly, the second ground voltage Vg (t2) divided by the second voltage dividing resistance 57 and the second voltage detection resistance 55 is input to the voltage detection unit 59. By providing a voltage dividing resistance in this manner, the voltage input to the voltage detection unit 59 can be controlled. Specifically, by setting the electric resistance of the voltage dividing resistance to be larger than the electric resistance of the voltage detection resistance, the voltage input to the voltage detection unit 59 can be reduced. This reduce the voltage input to parts (e.g., an amplifier) constituting the voltage detection unit 59 to a few V, and allows avoidance of direct input of the high voltage of several hundred V from the assembled battery 10. As a result, a commonly used part for signal processing can be used as a component of the voltage detection unit 59. This allows further reduction in cost required for detection of the electric leakage occurring position.

(5) Reference Electrical Potential Difference Detection Unit

The reference electrical potential difference detection unit 60 is a circuit connected between the first terminal $T_1$ and the second terminal $T_2$ and configured to detect the reference electrical potential difference $V_S$. As mentioned above, in the present embodiment, the positive electrode electroconductive path 30 connected to the total positive terminal 12 of the power source unit 10 is regarded as the first terminal $T_1$, and the negative electrode electroconductive path 40 connected to the total negative terminal 14 is regarded as the second terminal $T_2$. Thus, the reference electrical potential difference $V_S$ detected in the present embodiment is a "total voltage Vt of the assembled battery 10" which is a sum of voltages of the single batteries 11A to 11N. The specific structure of the reference electrical potential difference detection unit 60 is not particularly limited, and a known voltage detection unit is applicable without particular limitations. Similarly to the electric leakage detection unit 50, it is preferred that the reference electrical potential difference detection unit 60 is connected to the control unit (not shown), and a timing when the reference electrical potential difference $V_S$ (the total voltage Vt) is measured is controlled.

2. Electric Leakage Detection Method

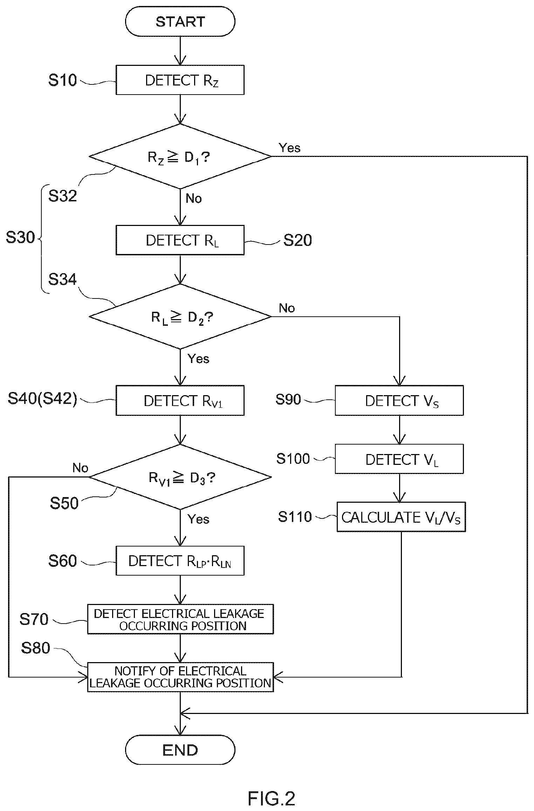

Broadly classified, the electric leakage in the electricity distribution system 100 with such a configuration includes a power source electric leakage S1 which occurs in the assembled battery 10 (the power source unit), a positive electrode-side electric leakage S2 which occurs in the positive electrode electroconductive path 30, a negative electrode-side electric leakage S3 which occurs in the negative electrode electroconductive path 40, and a device electric leakage S4 which occurs in the motor 20 (the electric device body) (see Fig. 1). The electric leakage detection method according to the present embodiment determines which of the electric leakages S1 to S4 is occurring. The following describes the electric leakage detection method according to the present embodiment with reference to the flowchart of Fig. 2.

As shown in Fig. 2, the electric leakage detection method according to the present embodiment includes first detection S10, second detection S20, and first determination S30. The electric leakage detection method according to the present embodiment further includes, in addition to S10 to S30, third detection S40, second determination S50, fourth detection S60, electric leakage occurring position determination S70, notification S80, fifth detection S90, sixth detection S100, seventh detection S110. Each process will be described below.

(1) First Detection S10

In this process, a value of a system electric leakage resistance $R_Z$ is detected with at least either one of the positive-side contactor 32 or the negative-side contactor 42 in Fig. 1 ON. The value of the system electric leakage resistance $R_Z$ is an electric leakage resistance of the entire system involving the power source electric leakage S1 in the assembled battery 10, the electrode-side electric leakage S2 in the positive electrode electroconductive path 30, the negative electrode-side electric leakage S3 in the negative electrode electroconductive path 40, and the device electric leakage S4 in the motor 20.

An example of the procedure of detecting the value of the system electric leakage resistance $R_Z$ will be described below. Here, the positive-side contactor 32 and the negative-side contactor 42 are both turned ON, and the assembled battery 10 and the motor 20 are connected to each other. In this state, when the first switch 52 of the electric leakage detection unit 50 is turned ON, and the second switch 53 is turned OFF, any of four electric leakages S1 to S4 is conducted with the first voltage detection resistance 54 via the ground. Accordingly, the first ground voltage $V_{g(t1)}$ is detected in the voltage detection unit 59. At the first timing t1, a first reference electrical potential difference $V_S$ (t1) (the first total voltage Vt (t1)) is also detected in the reference electrical potential difference detection unit 60. Then, when the first switch 52 is turned OFF, and the second switch 53 is turned ON with the assembled battery 10 and the motor 20 connected to each other, any of the electric leakage occurring positions S1 to S4 is conducted with the second voltage detection resistance 55 via the ground. Accordingly, the second ground voltage Vg (t2) is detected in the voltage detection unit 59. At the second timing t2, a second reference electrical potential difference $V_S$ (t2) (the second total voltage Vt (t2)) is also detected in the reference electrical potential difference detection unit 60. The first ground voltage $V_{g(t1)}$, the first reference electrical potential difference $V_S$ (t1), the second ground voltage Vg (t2), and the second reference electrical potential difference $V_S$ (t2) which are measured with the assembled battery 10 and the motor 20 connected to each other are substituted into the following equation (4), thereby calculating a system electric leakage resistance $R_Z$. In the equation (4), "Ra" represents the electric resistance of the electric resistances of the first voltage detection resistance 54 and the second voltage detection resistance 55, and "Rb" represents the electric resistances of the first voltage dividing resistance 56 and the second voltage dividing resistance 57. In the detection procedure, the positive-side contactor 32 and the negative-side contactor 42 are both turned ON when the assembled battery 10 and the motor 20 are connected to each other. However, in this process, at least either one of the positive-side contactor 32 or the negative-side contactor 42 may be turned ON. Also in this case, a close circuit via an electroconductive path on the side on which the contactor is ON and the electric leakage occurring positions S1 to S4 is formed. Thus, the first ground voltage $V_{g(t1)}$ and the second ground voltage Vg (t2) can be measured, and a system electric leakage resistance $R_Z$ can be calculated.

[Math. 4]

$$R_Z = \frac{R_a}{\frac{V_g(t_1)}{V_S(t_1)} + \frac{V_g(t_2)}{V_S(t_2)}} - (R_a + R_b) \qquad (4)$$

(2) Entire Determination S32

The first determination S30 in the present embodiment includes entire determination S32 of determining whether or not an electric leakage is occurring in the electricity distribution system 100. Specifically, in this process, the value of the system electric leakage resistance $R_Z$ detected in the first detection S10 is compared with a predetermined first threshold value $D_1$. If the value of the system electric leakage resistance $R_Z$ is less than the first threshold value $D_1$ ($R_Z < D_1$), it is

determined that there is a portion with a low resistance in the electricity distribution system 100 (any of the electric leakages S1 to S4 is occurring), and the process proceeds to the second detection S20 (NO in S32). If the value of the system electric leakage resistance $R_Z$ is equal to or higher than the first threshold value $D_1$ ($R_Z \geq D_1$), it is determined that an electric leakage is not occurring in the entire electricity distribution system 100, and detection of the electric leakage is ended (YES in S32).

(3) Second Detection S20

In this process, a value of a power source-side electric leakage resistance $R_L$ is detected with the positive-side contactor 32 and the negative-side contactor 42 both OFF. As shown in Fig. 1, when the positive-side contactor 32 and the negative-side contactor 42 are both turned OFF, the assembled battery 10 and the motor 20 are disconnected, and a power source unit-side region A1 is only conducted. When an electric leakage resistance is detected in this state, the value of the power source-side electric leakage resistance $R_L$ which is an electric leakage resistance on the side of the power source unit (the assembled battery 10) is detected.

The detection procedure for the value of the power source-side electric leakage resistance $R_L$ is the same as the detection procedure for the value of the system electric leakage resistance $R_Z$ in the first detection S 10 except that the assembled battery 10 and the motor 20 are disconnected. In other words, in this process, firstly, the positive-side contactor 32 and the negative-side contactor 42 are turned OFF, the assembled battery 10 and the motor 20 are disconnected, the first switch 52 is turned ON, and the second switch 53 is turned OFF. At the third timing (t3), a third ground voltage Vg (t3) is detected in the voltage detection unit 59, and a third reference electrical potential difference $V_S$ (t3) (the third total voltage Vt (t3)) is detected in the reference electrical potential difference detection unit 60. Next, the first switch 52 is turned OFF, and the second switch 53 is turned ON with the positive-side contactor 32 and the negative-side contactor 42 OFF. At the fourth timing (t4), a fourth ground voltage Vg (t4) is detected in the voltage detection unit 59, and a fourth reference electrical potential difference $V_S$ (t4) (the fourth total voltage Vt (t4)) is detected in the reference electrical potential difference detection unit 60. The third ground voltage Vg (t3), the third reference electrical potential difference $V_S$ (t3), the fourth ground voltage Vg (t4), and the fourth reference electrical potential difference $V_S$ (t4) which are measured with the assembled battery 10 and the motor 20 disconnected to each other are substituted into the following equation (5), there by calculating a power source-side electric leakage resistance $R_L$.
[Math. 5]

$$RL = \frac{Ra}{\dfrac{Vg(t_3)}{V_S(t_3)} + \dfrac{Vg(t_4)}{V_S(t_4)}} - (Ra + Rb) \qquad (5)$$

(4) Region Determination S34

Next, the first determination S30 of the present embodiment includes region determination S34 of determining whether an electric leakage is occurring in the power source unit-side region A1 or the electric device-side region A2. In the region determination S34, the value of the power source-side electric leakage resistance $R_L$ detected in the second detection S20 is compared with a second threshold value $D_2$. If the value of the power source-side electric leakage resistance $R_L$ is less than the second threshold value $D_2$ ($R_L < D_2$), it is determined that there is a portion with a low resistance (an electric leakage is occurring) in a region on the power source unit-side region A1. In this case, the electric leakage detection process proceeds to the fifth detection S90 (NO in S34). In the subsequent processes S90 to S110, which portion in the power source unit-side region A1 is causing the electric leakage is detected. If the value of the power source-side electric leakage resistance $R_L$ is equal to or higher than the second threshold value $D_2$ ($R_L \geq D_2$), it is determined that the power source-side electric leakage resistance $R_L$ has sufficiently high resistance (an electric leakage is not occurring). Thus, it is further determined that the electric leakage determined in the entire determination S32 is occurring in a region (i.e., the electric device-side region A2) different from the power source unit-side region A1. In this case, the electric leakage detection process proceeds to the third detection S40 (YES in S34). Then, in the subsequent processes S40 to S70, which portion in the electric device-side region A2 is causing the electric leakage is detected.

In this manner, the electric leakage detection method according to the present embodiment can determine which of the power source unit-side region A1 or the electric device-side region A2 is causing the electric leakage based on the values of the system electric leakage resistance $R_Z$ and the power source-side electric leakage resistance $R_L$ by the first determination S30 (the entire determination S32 and the region determination S34). Then, the electric leakage resistances of the system electric leakage resistance $R_Z$ and the power source-side electric leakage resistance $R_L$ can be detected by switching connection and disconnection between the assembled battery 10 and the motor 20. Thus, the electric leakage occurring position in the electricity distribution system 100 can be determined at low cost in a simplified manner.

(5) Third Detection S40

Next, in the electric leakage detection method according to the present embodiment, the third detection S40 of calculating a value of the device-side electric leakage resistance $R_V$ which is an electric leakage resistance near the motor 20. The value of the device-side electric leakage resistance $R_V$ is a composite value of the electric leakage resistances present in the electric device-side region A2. Specifically, the value of the device-side electric leakage resistance $R_V$ includes a value of the positive electrode-side electric leakage resistance $R_{LP}$ which is a resistance of the electrode-side electric leakage S2, a value of the negative electrode-side electric leakage resistance $R_{LN}$ which is a resistance of the negative electrode-side electric leakage S3, and a value of a device electric leakage resistance RM which is a resistance of the device electric leakage S4. The calculation of the device-side electric leakage resistance $R_V$ allows the degree of the electric leakage occurring in the electric device-side region A2 to be determined in a simplified manner. The value of the device-side electric leakage resistance $R_V$ can be calculated by substituting the values of the system electric leakage resistance $R_Z$ and the power source-side electric leakage resistance $R_L$ into the following equation (1).
[Math. 6]

$$Rv = \frac{Rz \cdot RL}{RL - Rz} \qquad (1)$$

In the third detection S40 in the present embodiment, S42 of detecting a value of the first device-side electric leakage resistance $R_{V1}$ which is a value of the device-side electric leakage resistance $R_V$ when the motor 20 is at rest is performed. Specifically, at least either one of the positive-side contactor 32 or the negative-side contactor 42 is turned ON, and the motor 20 is stopped with the assembled battery 10 and the motor 20 connected to each other. In this state, a value of the system electric leakage resistance $R_Z$ is detected in the same procedure as in the first detection S10. Then, the value of the system electric leakage resistance $R_Z$ when the motor 20 is at rest and the value of the power source-side electric leakage resistance $R_L$ detected in the second detection S20 are substituted into the equation (1), thereby calculating a value of the first device-side electric leakage resistance $R_{V1}$ which is a value of the device-side electric leakage resistance $R_V$ when the motor 20 is at rest.

(6) Second Determination S50

In this process, which of the motor 20 or the electric device-side region A2 excluding the motor 20 (i.e., any of the positive electrode electroconductive path 30, the negative electrode electroconductive path 40, and the inverter 25) is causing the electric leakage is determined based on the value of the first device-side electric leakage resistance $R_{V1}$. Specifically, in the second determination S50 in the present embodiment, the value of the first device-side electric leakage resistance $R_{V1}$ detected in the third detection S40 is compared with the third threshold value $D_3$. If the value of the first device-side electric leakage resistance $R_{V1}$ is equal to or higher than the third threshold value $D_3$ ($R_{V1} \geq D_3$), it is determined that there is a portion with a low resistance with the motor 20 at rest (an electric leakage is occurring in a portion other than the motor 20). In this case, in the electric leakage detection method according to the present embodiment, it is determined that an electric leakage is occurring in the electric device-side region A2 excluding the motor 20, and the process proceeds to the fourth detection S60 (YES in S50). If the value of the first device-side electric leakage resistance $R_{V1}$ is less than the third threshold value $D_3$ ($R_{V1} < D_3$), it is determined that the entire electricity distribution system 100 has a high resistance with the motor 20 at rest (an electric leakage is not occurring). In this case, in the electric leakage detection method according to the present embodiment, it is determined that the device electric leakage S4 in the motor 20 is a main electric leakage, and the process proceeds to the notification S80 (NO in S50). Then, in the notification S80, a user is notified of the device electric leakage S4 occurring, and the process ends.
As described above, in the electric leakage detection method according to the present embodiment, when electric leakage is occurring in electric device-side region A2, determination based on the value of the first device-side electric leakage resistance $R_{V1}$ with the motor 20 at rest is performed. Accordingly, which of the electric device (the motor 20) and the electric device-side region A2 excluding the motor 20 (i.e., any of the positive electrode electroconductive path 30, the negative electrode electroconductive path 40, and the inverter 25) is causing the electric leakage can be determined in detail.

(7) Fourth Detection S60

As mentioned above, in the electric leakage detection method according to the present embodiment, if it is determined that electric leakage is occurring in electric device-side region A2 excluding the motor 20 in the second determination S50 (YES in S50), the fourth detection S60 of detecting values of the positive electrode-side electric leakage resistance $R_{LP}$ and the negative electrode-side electric leakage resistance $R_{LN}$ is performed. The value of the positive electrode-side electric leakage resistance $R_{LP}$ is an electric leakage resistance of the positive electrode electroconductive path 30 between the motor 20 and the positive-side contactor 32. The value of the negative electrode-side electric leakage resistance $R_{LN}$ is an electric leakage resistance of the negative electrode electroconductive path 40 between the motor 20 and the negative-side contactor 42.

An example of the procedure of detecting (calculating) values of the positive electrode-side electric leakage resistance $R_{LP}$ and the negative electrode-side electric leakage resistance $R_{LN}$ will be described below. In the present embodiment, firstly, the first ground voltage $V_{g(t1)}$ and the second ground voltage Vg (t2) are obtained in the same procedure as in the first detection S 10 (detection of the value of the system electric leakage resistance $R_Z$). In other words, at least either one of the positive-side contactor 32 or the negative-side contactor 42 is turned ON, and the assembled battery 10 and the motor 20 are electrically connected to each other. In this state, the first switch 52 is turned ON, and the second switch 53 is turned OFF, and then, the first ground voltage $V_{g(t1)}$ is detected in the voltage detection unit 59. Then, at the timing when the first ground voltage $V_{g(t1)}$ is obtained, the first reference electrical potential difference $V_S$ (t1) (the first total voltage Vt (t1)) is measured. Subsequently, the first switch 52 is turned OFF and the second switch 53 is turned ON with at least either one of the positive-side contactor 32 or the negative-side contactor 42 ON, and the second ground voltage Vg (t2) is detected in the voltage detection unit 59. Then, at the timing when the second total voltage Vt (t2) is obtained, the second reference electrical potential difference $V_S$ (t2) (the second ground voltage Vg (t2)) is again measured.

In the present embodiment, the values of the positive electrode-side electric leakage resistance $R_{LP}$ and the negative electrode-side electric leakage resistance $R_{LN}$ are calculated based on the first ground voltage $V_{g(t1)}$, the first reference electrical potential difference $V_S$ (t1), the second ground voltage Vg (t2), the second reference electrical potential difference $V_S$ (t2), and the value of the system electric leakage resistance $R_Z$ which are obtained in the procedures described above. The positive electrode-side electric leakage resistance $R_{LP}$ is calculated based on the following equation (2), and the negative electrode-side electric leakage resistance $R_{LN}$ is calculated based on the following equation (3).

[Math. 7]

$$R_{LP} = \left[ 1 + \frac{V_g(t_1)}{V_g(t_2)} \cdot \frac{V_S(t_2)}{V_S(t_1)} \right] \cdot R_Z \qquad (2)$$

[Math. 8]

$$R_{LN} = \left[ 1 + \frac{V_g(t_2)}{V_g(t_1)} \cdot \frac{V_S(t_1)}{V_S(t_2)} \right] \cdot R_Z \qquad (3)$$

(8) Electric Leakage Occurring Position Determination S70

In this process, a detailed electric leakage occurring position in the electric device-side region A2 excluding the motor 20 is determined based on the values of the positive electrode-side electric leakage resistance $R_{LP}$ and the negative electrode-side electric leakage resistance $R_{LN}$ calculated in the fourth detection S60. For example, in this process, the value of the positive electrode-side electric leakage resistance $R_{LP}$ may be compared with a sixth threshold value $D_6$, and the value of the negative electrode-side electric leakage resistance $R_{LN}$ may be compared with the sixth threshold value $D_6$. At this time, if the value of the positive electrode-side electric leakage resistance $R_{LP}$ is equal to or less than the sixth threshold value $D_6$, it is determined that the electric leakage is occurring in the positive electrode electroconductive path 30. If the value of the negative electrode-side electric leakage resistance $R_{LN}$ is equal to or less than the sixth threshold value $D_6$, it is determined that the electric leakage is occurring in the negative electrode electroconductive path 40. In addition, if both values of the positive electrode-side electric leakage resistance $R_{LP}$ and the negative electrode-side electric leakage resistance $R_{LN}$ exceed the sixth threshold value $D_6$, the positive electrode electroconductive path 30 and the negative electrode electroconductive path 40 are both maintained to have high resistance. Thus, it is determined that the electric leakage is occurring in a common device to the positive electrode electroconductive path 30 and the negative electrode electroconductive path 40 (e.g., the inverter 25). Then, in the subsequent notification S80, the user is notified of the determination result in this process.

(9) Fifth Detection S90

If the power source unit (the assembled battery 10) including multiple power sources (single batteries 11A to 11N) connected in series as in Fig. 1 is used, it is preferred that S90 to S110 are performed after it is determined that the electric leakage is occurring in the power source unit-side region A1 in the first determination S30 (the region determination S34). This allows which portion of the assembled battery 10 is causing the electric leakage to be determined in detail.

In the fifth detection S90, two types of the first terminal $T_1$ and the second terminal $T_2$ are connected to the predetermined position of the power source unit, and the reference electrical potential difference $V_S$ which is an electrical potential difference between the first terminal $T_1$ and the second terminal $T_2$ is obtained. As mentioned above, in the present embodiment, the positive electrode electroconductive path 30 is regarded as the first terminal $T_1$, and the negative electrode electroconductive path 40 is regarded as the second terminal $T_2$. Thus, the reference electrical potential difference $V_S$ measured in the reference electrical potential difference detection unit 60 is a "total voltage Vt of the assembled battery 10."

(10) Sixth Detection S 100

In this process, either one of the first terminal $T_1$ (the positive electrode electroconductive path 30) or the second terminal $T_2$ (the negative electrode electroconductive path 40) is used as the reference terminal, and a power source-side electric leakage voltage $V_L$ which is an electrical potential difference between the reference terminal and the electric leakage occurring position is calculated. Specifically, a voltage generated via the power source electric leakage S1 is measured, and the power source-side electric leakage voltage $V_L$ is calculated based on the voltage measured. The following describes procedures of calculating the power source-side electric leakage voltage $V_L$ with reference to the case where the second terminal $T_2$ (the negative electrode electroconductive path 40) is used as the reference terminal as an example.

In this process, as in the second detection S20, the positive-side contactor 32 and the negative-side contactor 42 are both turned OFF, and the assembled battery 10 and the motor 20 are disconnected to each other. Then, in this state, the first switch 52 is turned ON, the second switch 53 is turned OFF, and the third ground voltage Vg (t3) is detected in the voltage detection unit 59. At the third timing, the third reference electrical potential difference $V_S$ (t3) (the third total voltage Vt (t3)) is also measured in the reference electrical potential difference detection unit 60. Then, with the assembled battery 10 and the motor 20 disconnected to each other, the first switch 52 is turned OFF, the second switch 53 is turned ON, and the fourth ground voltage Vg (t4) is measured in the voltage detection unit 59. At the fourth timing, the fourth reference electrical potential difference $V_S$ (t4) (the fourth total voltage Vt (t4)) is also measured in the reference electrical potential difference detection unit 60. The voltages obtained in this process may be voltage detected in the second detection S20.

The power source-side electric leakage voltage $V_L$ is represented by the following equation (6). In the following equation (6), "k" represents the ratio ($V_L/V_S$) of the power source-side electric leakage voltage $V_L$ to the reference electrical potential difference $V_S$, and is a numerical value in the range of 0 or more to 1 or less.
[Math. 9]

$$V_L(t) = kV_S(t) \qquad (6)$$

In the equation (6), "k" can be calculated by the following equation (7). In the following equation (7), the third ground voltage Vg (t3) and the fourth ground voltage Vg (t4) are synthesized. This reduces the influence of variations in reference electrical potential difference $V_S$ and power source-side electric leakage voltage $V_L$ due to charging/discharging, electric leakage, and the like, and the ratio ($k = V_L/V_S$) of the power source-side electric leakage voltage $V_L$ to the reference electrical potential difference $V_S$ can be calculated accurately.
[Math. 10]

$$k = \frac{\dfrac{V_S(t_3)}{V_S(t_4)}}{\dfrac{V_g(t_3)}{V_g(t_4)} + \dfrac{V_S(t_3)}{V_S(t_4)}} \qquad (7)$$

(11) Seventh Detection S110

In this process, the distance from the reference terminal to the electric leakage occurring position is detected based on the ratio ($V_L/V_S$) of the power source-side electric leakage voltage $V_L$ to the reference electrical potential difference Vs. For example, in the present embodiment, the total voltage Vt of the assembled battery is used as a reference electrical potential difference $V_S$. Thus, the ratio k (= $V_L/Vt$) of the electric leakage voltage $V_L$ to the total voltage Vt is calculated by the equation (7). Based on the ratio k of the power source-side electric leakage voltage $V_L$ to the total voltage Vt, the distance from the reference terminal (the negative electrode electroconductive path 40) to the electric leakage occurring position (the power source electric leakage S1) can be determined in a simplified manner.

For example, in the case where, in an assembled battery (total voltage Vt: about 355 V) where 96 batteries of 3.7 V are connected in series, the power source-side electric leakage voltage $V_L$ is 100 V with the second terminal $T_2$ (the negative electrode electroconductive path 40 used as the reference terminal, the $V_L/V_S$ is 0.28. In this case, 96 (batteries) $\times$ ($V_L/V_S$) = 27.04. Based on the calculation results, it can be determined that an electric leakage is occurring in the vicinity of the 27th single battery (e.g., a single battery body and a connection member) viewed from the single battery 11N connected to the reference terminal (the negative electrode electroconductive path 40). If $V_L/V_S$ = 0, it can be detected that the electric leakage is occurring in the negative electrode electroconductive path 40 or the n-th single battery 11N in the power source unit-side region A1. If $V_L/V_S$ = 1, it can be determined that the electric leakage is occurring in the positive electrode electroconductive path 30 or the first single battery 11A in the power source unit-side region A1. In the electric leakage detection method according to the present embodiment, the process proceeds to the notification S80 after this process, and the user is notified of the detailed electric leakage occurring position in the power source unit-side region A1, and the process ends.

As described above, according to the electric leakage detection method according to the present embodiment, a main electric leakage occurring position can be accurately determined among four types of electric leakage occurring positions including the power source electric leakage S1 in the power source unit, the electrode-side electric leakage S2 in the positive electrode electroconductive path 30, the negative electrode-side electric leakage S3 in the negative electrode electroconductive path 40, and the device electric leakage S4 in electric device body.

As the threshold values ($D_1$, $D_2$, $D_3$, and $D_6$) used in each determination, values determined so that each determination functions appropriately can be set as appropriate. The threshold values may vary depending on the configuration of the power source unit and the electric device, and thus are not limited to specific values. It is preferred that values obtained by preliminary tests are used as the threshold values.

<Second Embodiment>

The first embodiment of the electric leakage detection method disclosed herein is described above. The embodiment is not intended to limit the electric leakage detection method disclosed herein, and various changes can be made. For example, in the first embodiment, which of the power source unit-side region A1 or the electric device-side region A2 is causing the electric leakage is determined in the first determination S30, and then S40 to S110 are performed. Thus, more detailed electric leakage occurring position is determined. However, the electric leakage detection method disclosed herein is not particularly limited as long as which of the power source unit-side region A1 or the electric device-side region A2 is causing the electric leakage is causing the electric leakage can be determined based on the values of the system electric leakage resistance $R_Z$ and the power source-side electric leakage resistance $R_L$ In other words, S40 to S 110 in the first embodiment may be omitted. In such a case, an electric leakage occurring position in the electricity distribution system where the power source unit and the electric device are electrically connected to each other can be determined at low cost and in a simplified manner.

<Third Embodiment>

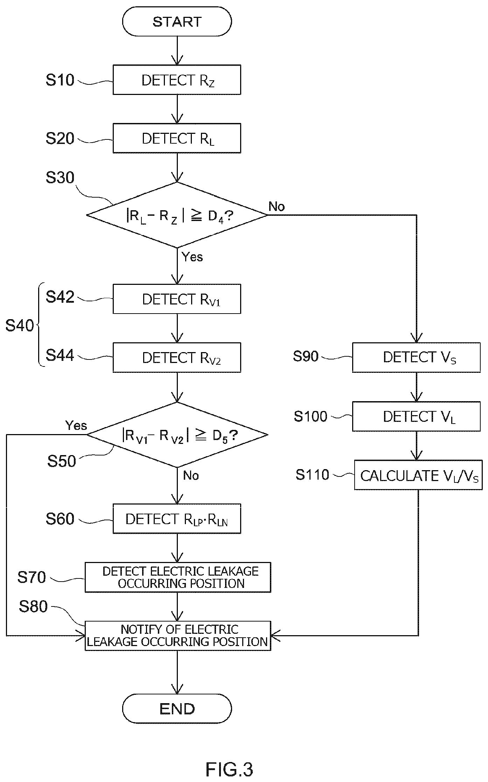

The electric leakage detection method disclosed herein is not limited to the procedures shown in Fig. 2, and can be performed according to different procedures. The following describes the third embodiment of the electric leakage detection method disclosed herein with reference to different points from the first embodiment. Fig. 3 is a flowchart illustrating an electric leakage detection method according to a fourth embodiment.

(1) Change Example of First Determination

In the first determination S30 in the first embodiment, two determinations of the entire determination S32 and the region determination S34 are performed. Thus, which of the power source unit-side region A1 or the electric device-side region A2 is causing the electric leakage can be determined (see Fig. 2). However, the first determination is not limited to the first determination S30 described in the first embodiment as long as a region where the electric leakage is occurring can be determined based on the values of the system electric leakage resistance $R_Z$ and the power source-side electric leakage resistance $R_L$. For example, in the first determination S30 of the second embodiment, as shown in Fig. 3, an absolute value $|R_L - R_Z|$ of the difference between the values of the power source-side electric leakage resistance $R_L$ and the system electric leakage resistance $R_Z$ is calculated, and is compared with the fourth threshold value $D_4$.

If the absolute value $|R_L - R_Z|$ of the difference is equal to or higher than the fourth threshold value $D_4$ ($|R_L - R_Z| \geq D_4$), values of the power source-side electric leakage resistance $R_L$ and the system electric leakage resistance $R_Z$ largely differ from each other. Thus, it is determined that an electric leakage is occurring in a region (i.e., the electric device-side region A2) different from the power source unit-side region A1, and the process proceeds to the third detection S40 (YES in S30). If the absolute value $|R_L - R_Z|$ of the difference is less than the fourth threshold value $D_4$ ($|R_L - R_Z| < D_4$), the values of the power source-side electric leakage resistance $R_L$ and the system electric leakage resistance $R_Z$ are approximate. Thus it is determined that the electric leakage is occurring in the power source unit-side region A1, and the process proceeds to the fifth detection S90 (NO in S30). As described above, even when the absolute value $|R_L - R_Z|$ of the difference between the values of the power source-side electric leakage resistance $R_L$ and the system electric leakage resistance $R_Z$ is calculated, which of the power source unit-side region A1 or the electric device-side region A2 is causing the electric leakage can be determined.

(3) Change Example of Second Determination

In the second determination S50 of the first embodiment, the value of the first device-side electric leakage resistance $R_{V1}$ when the electric device is at rest is compared with the third threshold value $D_3$, and which of the electric device (the motor 20) or the electric device-side region A2 excluding the electric device (the motor 20) is causing the electric leakage is determined. However, the second determination is not limited to the second determination S50 shown in the first embodiment as long as the electric leakage occurring position can be determined based on the value of the first device-side electric leakage resistance $R_{V1}$. For example, in the third embodiment, as shown in Fig. 3, the value of the first device-side electric leakage resistance $R_{V1}$ when the electric device is at rest and the second device-side electric leakage resistance $R_{V2}$ when the electric device is in operation are measured, and the absolute value $|R_{V1} - R_{V2}|$ of the difference of these electric leakage resistances is calculated. Then, the absolute value $|R_{V1} - R_{V2}|$ of the difference is compared with a fifth threshold value $D_5$. Thus, which of the electric device (the motor 20) or the electric device-side region A2 excluding the electric device (the motor 20) is causing the electric leakage can be determined.

Specifically, in the electric leakage detection method according to the second embodiment, in the third detection S40, not only S42 of detecting the value of the first device-side electric leakage resistance $R_{V1}$ which is the value of the device-side electric leakage resistance $R_V$ when the motor 20 is at rest, but also S44 of detecting the value of the second device-side electric leakage resistance $R_{V2}$ which is the value of the device-side electric leakage resistance $R_V$ when the motor 20 is in operation are performed. The value of the second device-side electric leakage resistance $R_{V2}$ can be detected by calculating the value of the device-side electric leakage resistance $R_V$ in accordance with the same procedures as for the first device-side electric leakage resistance $R_{V1}$ except that the electric device (the motor 20) is in operation. Thus, description of detailed calculation process is omitted.

In the second determination S50 in the present embodiment, the absolute value $|R_{V1} - R_{V2}|$ of the difference between the values of the first device-side electric leakage resistance $R_{V1}$ and the second device-side electric leakage resistance $R_{V2}$ detected in the third detection S40 is calculated, and si then compared with the fifth threshold value $D_5$. When the absolute value $|R_{V1} - R_{V2}|$ of the difference is less than the fifth threshold value $D_5$ ($|R_{V1} - R_{V2}| < D_5$), it is determined that the electric leakage resistance when the motor 20 is in operation and the electric leakage resistance when the motor 20 is at rest are approximate. In such a case, in the electric leakage detection method according to the present embodiment, it is determined that a portion other than the motor 20 (i.e., any of the positive electrode electroconductive path 30, the negative electrode electroconductive path 40, and the inverter 25) is causing electric leakage, and the process proceeds to the fourth detection S60 (NO in S50). If the absolute value $|R_{V1} - R_{V2}|$ of the difference is equal to or higher than the fifth threshold value $D_5$ ($|R_{V1} - R_{V2}| \geq D_5$), the electric leakage resistance when the motor 20 is in operation and the electric leakage resistance when the motor 20 is at rest greatly differ from each other. Thus, it is determined that the electric leakage is occurring in the motor 20, and the process proceeds to the notification S80 (YES in S50).

As described above, in the electric leakage detection method disclosed herein, not direct comparison between the electric leakage resistance detected and the threshold value, but calculation of the absolute value of the difference between two electric leakage resistances and determination of whether or not the electric leakage resistances are approximate can be employed when the electric leakage occurring position is determined.

<Fourth Embodiment>

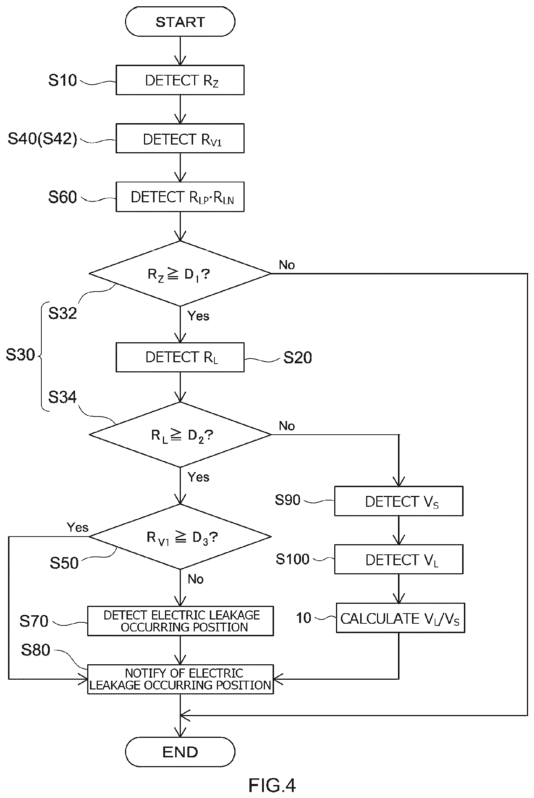

Next, the timings when the first detection S10, the second detection S20, the third detection S40, the fourth detection S60, and the sixth detection S 100 in the first embodiment do not limit the technology disclosed herein. In other words, the timing when each detection process is performed may be changed appropriately if necessary. The following describes the fourth embodiment of the electric leakage detection method disclosed herein with reference to different points from the first embodiment. Fig. 4 is a flowchart illustrating an electric leakage detection method according to a fourth embodiment.

As shown in Fig. 4, in the electric leakage detection method according to the fourth embodiment, firstly, the first detection S 10 of detecting the value of the system electric leakage resistance $R_Z$, the third detection S40 of detecting the value of the device-side electric leakage resistance $R_V$, and the fourth detection S60 of detecting values of the positive electrode-side electric leakage resistance $R_{LP}$ and the negative electrode-side electric leakage resistance $R_{LN}$ are performed in advance. In other words, in the fourth embodiment, parameters (values of the system electric leakage resistance $R_Z$, the device-side electric leakage resistance $R_V$, the positive electrode-side electric leakage resistance $R_{LP}$, and the negative electrode-side electric leakage resistance $R_{LN}$) are firstly detected with the assembled battery 10 and the motor 20 connected to each other (at the first timing (t1) and the second timing (t2)). Then, parameters (value of the power source-side electric leakage resistance $R_L$ and the power source-side electric leakage voltage $V_L$) detected with the assembled battery 10 and the motor 20 disconnected to each other (at the third timing (t3) and the fourth timing (t4)) are detected. This eliminates the need to frequently switch ON/OFF of the contactor. Accordingly, the electric leakage can be detected safely in a short time.

<Fifth Embodiment>

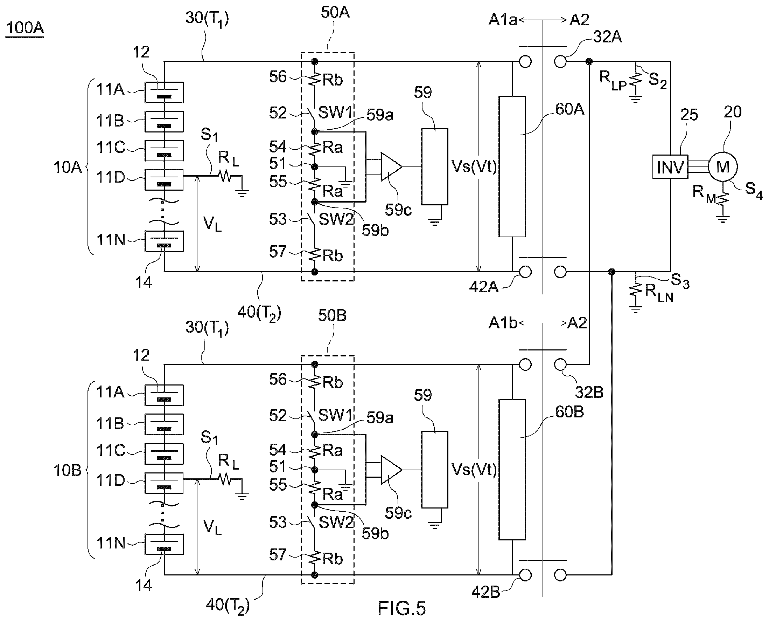

The electric leakage detection method disclosed herein is not limited by the form in which a specific circuit or calculation formula is used. For example, the electric leakage detection method disclosed herein can be performed without particular limitations as long as it includes a positive-side contactor and a negative-side contactor and a circuit which can detect the value of the system electric leakage resistance $R_Z$ and the power source-side electric leakage resistance $R_L$ is constructed. In other words, the electric leakage detection method disclosed herein is applicable to the electricity distribution system with different structure from the electricity distribution system 100 shown in Fig. 1. The following describes a fifth embodiment employing an electricity distribution system with different structure from Fig. 1. Fig. 5 is a circuit diagram illustrating an electricity distribution system for performing an electric leakage detection method according to the fifth embodiment.

As shown in Fig. 5, in the electricity distribution system 100 in the fifth embodiment, two assembled batteries 10A and 10B are connected to a single motor 20 in series. In the electricity distribution system 100, a first positive-side contactor 32A and a first negative-side contactor 42A are provided between the first assembled battery 10A and the motor 20. The second positive-side contactor 32B and the second negative-side contactor 42B are provided bewteen the second assembled battery 10B and the motor 20. In the present embodiment, the power source unit-side region including the first assembled battery 10A is referred to as a "first region A1a," and the power source unit-side region including the second assembled battery 10B is referred to as a "second region A1b." The other configuration is the same as the electricity distribution system 100 (see Fig. 1) in the first embodiment, and the detailed description thereof is omitted.

In the electricity distribution system 100 with such a configuration, all assembled batteries 10A and 10B and the motor 20 are electrically connected to each other by turning all the first positive-side contactor 32A, the first negative-side contactor 42A, the second positive-side contactor 32B, and the second negative-side contactor 42B ON. The electric leakage resistance is detected by using the electric leakage detection circuit 50A near the first assembled battery 10A in this state, thereby obtaining a value of the system electric leakage resistance $R_Z$. In the detection of the value of the system electric leakage resistance $R_Z$, the electric leakage detection circuit 50B near the second assembled battery 10B may also be used. By turning all the first positive-side contactor 32A, the first negative-side contactor 42A, a second positive-side contactor 32B, and the second negative-side contactor 42B OFF, all assembled batteries 10A and 10B and the motor 20 are disconnected. In this case, in the first region A1a, the value of the first power source-side electric leakage resistance $R_{L1}$ is detected, and in the second region A1b, the value of the second power source-side electric leakage resistance $R_{L2}$ is detected.

In this case, by performing the following processes, the electric leakage occurring position can be determined based on the values of the system electric leakage resistance $R_Z$, the first power source-side electric leakage resistance $R_{L1}$, and the second power source-side electric leakage resistance $R_{L2}$. Firstly, entire determination of comparing the value of the system electric leakage resistance $R_Z$ with a predetermined first threshold value $D_1$ is performed. Then, if the value of the system electric leakage resistance $R_Z$ is equal to or higher than the first threshold value $D_1$ ($R_Z \geq D_1$), it is determined that the electric leakage is not occurring in the electricity distribution system 100, and the detection of the electric leakage ends. If the value of the system electric leakage resistance $R_Z$ is less than the first threshold value $D_1$ ($R_Z < D_1$), it is determined that an electric leakage is occurring in the electricity distribution system 100.

Then, in the fifth embodiment, if it is determined that an electric leakage is occurring in the electricity distribution system 100, the value of the first power source-side electric leakage resistance $R_{L1}$ derived from the first region A1a is compared with a second threshold value $D_2$. Then, if the value of the first power source-side electric leakage resistance $R_{L1}$ is less than the second threshold value $D_2$ ($R_{L1} < D_2$), it is determined that an electric leakage is occurring in the first region A1a. If the value of the first power source-side electric leakage resistance $R_L$ is equal to or higher than the second threshold value $D_2$ ($R_{L1} \geq D_2$), it is determined that the electric leakage is occurring in either the second region A1b or the electric device-side region A2. In this case, in the electric leakage detection method according to the fifth embodiment, the value of the second power source-side electric leakage resistance $R_{L2}$ derived from the second region A1b is compared with the second threshold value $D_2$. If the value of the second power source-side electric leakage resistance $R_{L2}$ is less than the second threshold value $D_2$ ($R_{L2} < D_2$), it is determined that the electric leakage is occurring in the second region A1b. If the value of the second power source-side electric leakage resistance $R_{L2}$ is equal to or higher than the second threshold value $D_2$ ($R_{L2} \geq D_2$), it is determined that the electric leakage is occurring in the electric device-side region A2.

As described above, even when the electricity distribution system with a different structure from Fig. 1 is employed, the electric leakage occurring position can be determined based on the values of the system electric leakage resistance $R_Z$ and the power source-side electric leakage resistance $R_L$, and the electric leakage detection method disclosed herein can be performed.

<Sixth Embodiment>

In the embodiments, a pair of a positive-side contactor and a negative-side contactor is provided in a single power source unit. However, the number of positive-side contactors and negative-side contactors installed does not limit the technology disclosed herein. For example, the electric leakage detection method disclosed herein is applicable to the electricity distribution system in which multiple power source units share some of the positive-side contactors and the negative-side contactors.

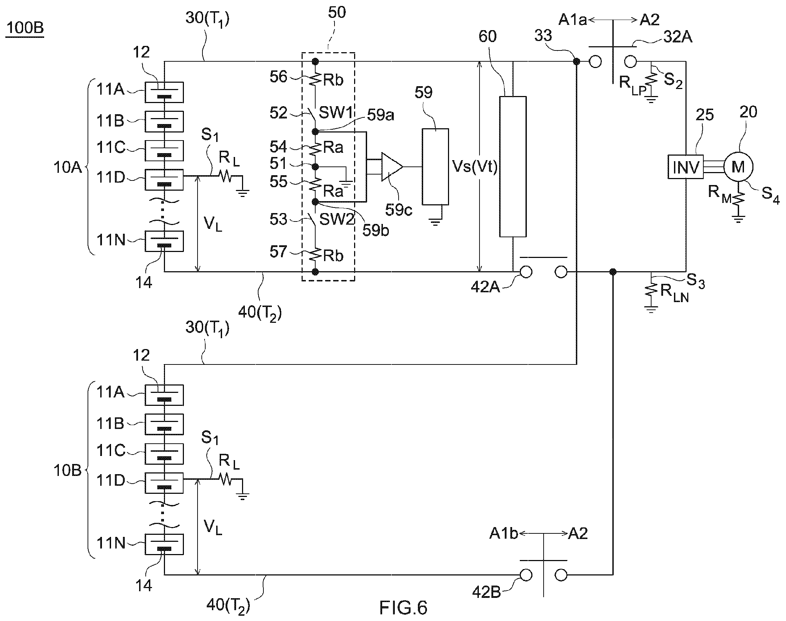

Fig. 6 is a circuit diagram illustrating an electricity distribution system for performing an electric leakage detection method according to the sixth embodiment. As in the fifth embodiment, in the electricity distribution system 100B in the sixth embodiment, two assembled batteries 10A and 10B are connected in series to a single motor 20. In the electricity distribution system 100B, the first region A1a and the second region A1b share the positive-side contactor 32A and the electric leakage detection unit 50. In other words, in the electricity distribution system 100B shown in Fig. 6, the positive electrode electroconductive path 30 connected to the first assembled battery 10A and the positive electrode electroconductive path 30 connected to the second assembled battery 10B are connected at a connection point 33, and a positive-side contactor 32A is provided between the connection point 33 and the motor 20. The electric leakage detection unit 50 is disposed between the positive electrode electroconductive path 30 and the negative electrode electroconductive path 40 in the first region A1a, but is not arranged in the second region A1b. The negative-side contactor in the present embodiment is arranged in each of the regions. In other words, the first negative-side contactor 42A is arranged in the negative electrode electroconductive path 40 connected to the first assembled battery 10A. The second negative-side contactor 42B is arranged in the negative electrode electroconductive path 40 connected to the second assembled battery 10B. The electricity distribution system 100B with such a configuration can contribute to the reduction in the number of parts and the manufacturing cost.

In the electricity distribution system 100B with such a configuration, by turning all the positive-side contactor 32A, the first negative-side contactor 42A, the second negative-side contactor 42B ON, the first assembled battery 10A, the second assembled battery 10B, and the motor 20 are electrically connected to each other. The detection of the electric leakage resistance in this state allows the value of the system electric leakage resistance $R_Z$ to be obtained. When the value of the power source-side electric leakage resistance $R_L$ is detected in the electricity distribution system 100B, the positive-side contactor 32A is turned OFF and the first negative-side contactor 42A and the second negative-side contactor 42B are turned ON. This disconnects the assembled batteries 10A and 10B and the motor 20, and forms the close circuit including the first assembled battery 10A, the second assembled battery 10B, and the electric leakage detection unit 50. Accordingly, the value of the power source-side electric leakage resistance $R_L$ including the electric leakage resistances of both the first assembled battery 10A and the second assembled battery 10B can be detected in the electric leakage detection unit 50. Thus, even in the electricity distribution system 100B with the configuration shown in Fig. 6, which of the power source unit-side region A1 or the electric device-side region A2 is causing the electric leakage can be determined based on the values of the system electric leakage resistance $R_Z$ and power source-side electric leakage resistance $R_L$.

<Other Changes>

In the embodiments, an assembled battery including multiple single batteries connected to each other is shown as an example of the power source unit which is an inspection target. However, the configuration of the power source unit does not limit the electric leakage detection method disclosed herein. For example, as mentioned above, the electric leakage detection method disclosed herein is applicable to the power source unit including multiple power generation elements (e.g., solar cells) connected to each other. In the embodiments, a power source unit (assembled battery) including power sources (single batteries) all of which are connected in series is an inspection target. However, it is not necessary that all of the power sources constituting the power source unit which is an inspection target are connected in series. For example, the electric leakage detection method disclosed herein can be used in the case of using the power source unit including multiple power sources connected in parallel.

In the embodiments, the positive electrode electroconductive path 30 is regarded as the first terminal $T_1$, and the negative electrode electroconductive path 40 is regarded as the second terminal $T_2$. However, the first terminal and the second terminal are not particularly limited as long as they are connected to positions of the power source unit with different electrical potentials. For example, the first terminal may be connected to a single battery different from the first single battery 11A in Fig. 1, and the second terminal may be connected to a single battery different from the N-th single battery 11N. In this case, a reference electrical potential difference detection unit is arranged between the first terminal and the second terminal. Then, in the reference electrical potential difference detection unit, an electrical potential difference between the first terminal and the second terminal (the total voltage of single batteries arranged between the first terminal and the second terminal) is measured, and the electrical potential difference is the reference electrical potential difference $V_S$. Even when such a reference electrical potential difference $V_S$ is used, the desired electric leakage resistance can be calculated based on the equations.

Although the technology disclosed herein has been described in detail above with specific embodiments, it is a mere example and does not limit the appended claims. The technology described is the appended claims include various modifications and changes of the foregoing embodiments.

**Claims**

1.   An electric leakage detection method of detecting an electric leakage occurring position in an electricity distribution system (100) where a power source unit (10) and an electric device (20) are electrically connected to each other,

the electricity distribution system (100) including:

a positive electrode electroconductive path (30) which connects between a positive electrode of the power source unit (10) and the electric device (20);
a negative electrode electroconductive path (40) which connects between a negative electrode of the power source unit (10) and the electric device (20);
a positive-side contactor (32) attached to the positive electrode electroconductive path (30) and configured to switch ON/OFF of connection between the power source unit (10) and the electric device (20); and
a negative-side contactor (42) attached to the negative electrode electroconductive path (40) and configured to switch ON/OFF of connection between the power source unit (10) and the electric device (2),

the electric leakage detection method comprising:

first detection of turning at least one of the positive-side contactor (32) or the negative-side contactor (42) ON and detecting a value of a system electric leakage resistance $R_Z$ which is an electric leakage resistance of the entire electricity distribution system (100);
second detection of turning both of the positive-side contactor (32) and the negative-side contactor (42) OFF and detecting a value of a power source-side electric leakage resistance $R_L$ which is a power source unit (10)-side electric leakage resistance; and
first determination of determining which of a power source unit-side region ($A_1$) or an electric device-side region ($A_2$) is causing the electric leakage based on the values of the system electric leakage resistance $R_Z$ and power source-side electric leakage resistance $R_L$, wherein
the electric leakage detection method further comprises third detection of calculating a value of a device-side electric leakage resistance $R_V$ which is an electric leakage resistance in the electric device, based on the following equation (1)

$$Rv = \frac{Rz \cdot RL}{RL - Rz} \qquad (1)$$

in the third detection, a value of a first device-side electric leakage resistance $R_{V1}$ which is a device-side electric leakage resistance $R_V$ when the electric device is at rest is calculated, and

the electric leakage detection method further comprises: second determination of determining which of the electric device or an electric device-side region (A2) excluding the electric device (20) is causing the electric leakage based on the value of the first device-side electric leakage resistance $R_{V1}$ if it is determined that the electric leakage is occurring in the electric device-side region (A2) in the first determination,

in the second determination, the value of the first device-side electric leakage resistance $R_{V1}$ is compared with a third threshold value $D_3$, it is determined that an electric leakage is occurring in the electric device (20) if the first device-side electric leakage resistance $R_{V1}$ is equal to or higher than the third threshold value $D_3$, and it is determined that an electric leakage is occurring in the electric device-side region (A2) excluding the electric device (20) if the value of the first device-side electric leakage resistance $R_{V1}$ is less than the third threshold value $D_3$, and

the electric leakage detection method further comprises fourth detection of detecting a value of a positive electrode-side electric leakage resistance $R_{LP}$ which is an electric leakage resistance of a positive electrode electroconductive path (30) and a value of a negative electrode-side electric leakage resistance $R_{LN}$ which is an electric leakage resistance of a negative electrode electroconductive path (40), wherein

the electric leakage detection method further comprises electric leakage occurring position determination of determining an electric leakage occurring position in the electric device-side region (A2) excluding the electric device (20), based on the values of the positive electrode-side electric leakage resistance $R_{LP}$ and the negative electrode-side electric leakage resistance $R_{LN}$ if it is determined that the electric leakage is occurring in the electric device-side region (A2) excluding the electric device (20) in the second determination,

in the fourth detection, at least one of the positive-side contactor (32) and the negative-side contactor (42) is turned ON.

2. The electric leakage detection method according to claim 1, wherein

the first determination includes:

entire determination of comparing the value of the system electric leakage resistance $R_Z$ with a first threshold value $D_1$, determining that an electric leakage is not occurring in the entire electricity distribution system (100) if the value of the system electric leakage resistance $R_Z$ is equal to or higher than the first threshold value $D_1$, and determining that an electric leakage is occurring in the electricity distribution system (100) if the value of the system electric leakage resistance $R_Z$ is less than the first threshold value $D_1$; and

region determination of comparing the value of the power source-side electric leakage resistance $R_L$ with a second threshold value $D_2$ if it is determined that the electric leakage is occurring in the electricity distribution system (100) in the entire determination, determining that the electric leakage is occurring in the electric device-side region (A2) if the value of the power source-side electric leakage resistance $R_L$ is equal to or higher than the second threshold value $D_2$, and determining that the electric leakage is occurring in the power source unit-side region (A1) if the power source-side electric leakage resistance $R_L$ is less than the second threshold value $D_2$.

3. The electric leakage detection method according to claim 2, wherein

in the first determination includes, an absolute value $|R_Z - R_L|$ of difference between the values of the system electric leakage resistance $R_Z$ and the power source-side electric leakage resistance $R_L$ is calculated, the absolute value $|R_Z - R_L|$ of the difference is compared with a fourth threshold value $D_4$, it is determined that an electric leakage is occurring in the electric device-side region (A2) if the absolute value $|R_Z - R_L|$ of the difference is equal to or higher than the fourth threshold value $D_4$, and it is determined that an electric leakage is occurring in the power source unit-side region (A1) if the value of the absolute value $|R_Z - R_L|$ of the difference is less than the fourth threshold value $D_4$.

4. The electric leakage detection method according to any one of claims 1 to 3, wherein

19

the electricity distribution system (100) includes:

a reference electrical potential difference detection unit (60) configured to detect a reference electrical potential difference Vs which is an electrical potential difference between a first terminal (12) connected to a predetermined position of the power source unit (10) and a second terminal (14) connected to a position with a different electrical potential from the first terminal (12); and
an electric leakage voltage detection unit connected to the first terminal (12) and the second terminal (14) and is connected to ground at its midpoint (51),

the electric leakage voltage detection unit includes:

a first switch (52) connected to the first terminal (12) side;
a first voltage detection resistance provided between the first switch (52) and the midpoint (51);
a second switch (53) connected to the second terminal (14) side; and
a second voltage detection resistor provided between the second switch (53) and the midpoint (51).

5. The electric leakage detection method according to claim 4, wherein

in the fourth detection, the value of the positive electrode-side electric leakage resistance $R_{LP}$ is calculated based on the following equation (2), and the value of the negative electrode-side electric leakage resistance $R_{LN}$ is calculated based on the following equation (3),

$$R_{LP} = \left[1 + \frac{V_g(t_1)}{V_g(t_2)} \cdot \frac{V_S(t_2)}{V_S(t_1)}\right] \cdot R_Z \qquad (2)$$

[Math. 3]

$$R_{LN} = \left[1 + \frac{V_g(t_2)}{V_g(t_1)} \cdot \frac{V_S(t_1)}{V_S(t_2)}\right] \cdot R_Z \qquad (3)$$

provided that in the equations (2) and (3), "$V_{g(t1)}$" represents a first ground voltage $V_{g(t1)}$ detected by the electric leakage voltage detection unit at a first timing t1 when the first switch (52) is turned ON and the second switch (53) is turned OFF with at least one of the positive-side contactor (32) or the negative-side contactor (42) ON, "Vs (t1)" represents a first reference electrical potential difference Vs (t1) detected by the reference electrical potential difference detection unit (60) at the first timing t1, "Vg (t2)" represents a second ground voltage Vg (t2) detected by the electric leakage voltage detection unit at a second timing t2 when the first switch (52) is turned OFF and the second switch (53) is turned ON with at least one of the positive-side contactor (32) or the negative-side contactor (42) ON, and "Vs (t2)" represents a second reference electrical potential difference Vs (t2) detected by the reference electrical potential difference detection unit (60) at the second timing t2.

6. The electric leakage detection method according to any one of claims 1 to 5, further comprising:

fifth detection of obtaining a reference electrical potential difference Vs which is an electrical potential difference between the first terminal (12) connected to a predetermined position of the power source unit (10) and the second terminal (14) connected to a portion with a different electrical potential from the first terminal (12) if it is determined that an electric leakage is occurring in the power source unit-side region (A1) in the first determination;
sixth detection of calculating a power source-side electric leakage voltage $V_L$ which is an electrical potential difference between the reference terminal and the electric leakage occurring position with either one of the first terminal (12) or the second terminal (14) as a reference terminal; and
seventh detection of detecting a distance from the reference terminal to the electric leakage occurring position based on the ratio ($V_L/V_S$) of the power source-side electric leakage voltage $V_L$ to the reference electrical potential difference Vs, wherein
the power source unit (10) includes multiple power sources (11A to 11N).

**Patentansprüche**

1. Verfahren zur Erfassung einer elektrischen Leckage zum Erfassen einer Ereignungsposition einer elektrischen Leckage in einem Elektrizitätsverteilungssystem (100), wo eine Leistungsquelleneinheit (10) und eine elektrische Vorrichtung (20) elektrisch miteinander verbunden sind, wobei das Elektrizitätsverteilungssystem (100) aufweist:

   einen elektrisch leitfähigen Weg (30) für eine positive Elektrode, welcher zwischen eine positive Elektrode der Leistungsquelleneinheit (10) und die elektrische Vorrichtung (20) geschaltet ist;
   einen elektrisch leitfähigen Weg (40) für eine negative Elektrode, welcher zwischen eine negative Elektrode der Leistungsquelleneinheit (10) und die elektrische Vorrichtung (20) geschaltet ist;
   einen Schaltschütz (32) für eine positive Seite, welcher an dem elektrisch leitfähigen Weg (30) für eine positive Elektrode angebracht und dafür eingerichtet ist, eine Verbindung zwischen der Leistungsquelleneinheit (10) und der elektrischen Vorrichtung (20) EIN/AUS zu schalten; und
   einen Schaltschütz (42) für eine negative Seite, welcher an dem elektrisch leitfähigen Weg (40) für eine negative Elektrode angebracht und dafür eingerichtet ist, eine Verbindung zwischen der Leistungsquelleneinheit (10) und der elektrischen Vorrichtung (20) EIN/AUS zu schalten,
   wobei das Verfahren zur Erfassung einer elektrischen Leckage aufweist:

   eine erste Erfassung eines EIN-Schaltens von entweder dem Schaltschütz (32) für die positive Seite oder dem Schaltschütz (42) für die negative Seite und Erfassen eines Werts von einem elektrischen Leckagewiderstand $R_Z$ eines Systems, welcher ein elektrischer Leckagewiderstand des gesamten Elektrizitätsverteilungssystem (100) ist;
   eine zweite Erfassung eines AUS-Schaltens von sowohl dem Schaltschütz (32) für die positive Seite als auch dem Schaltschütz (42) für die negative Seite und Erfassen eines Werts von einem auf der Leistungsquellenseite befindlichen elektrischen Leckagewiderstand $R_L$, welcher ein auf der Seite der Leistungsquelle (10) befindlicher elektrischer Leckagewiderstand ist; und
   eine erste Bestimmung eines Bestimmens, welcher von einem auf der Leistungsquellenseite befindlichen Bereich ($A_1$) oder einem auf einer elektrischen Vorrichtungsseite befindlichen Bereich ($A_2$) die elektrische Leckage verursacht, basierend auf den Werten des elektrischen Leckagewiderstands $R_Z$ des Systems und des auf der Leistungsquellenseite befindlichen elektrischen Leckagewiderstands $R_L$, wobei
   das Verfahren zur Erfassung einer elektrischen Leckage ferner eine dritte Erfassung eines Berechnens von einem Wert von einem auf der Vorrichtungsseite befindlichen elektrischen Leckagewiderstand $R_V$ aufweist, welcher ein elektrischer Leckagewiderstand in der elektrischen Vorrichtung ist, basierend auf der folgenden Gleichung (1)

$$Rv = \frac{Rz \cdot RL}{RL - Rz} \qquad (1)$$

   wobei, bei der dritten Erfassung, ein Wert von einem auf der Vorrichtungsseite befindlichen ersten elektrischen Leckagewiderstand $R_{V1}$, welcher ein auf der Vorrichtungsseite befindlicher elektrischer Leckagewiderstand $R_V$ ist, wenn die elektrische Vorrichtung im Ruhebetrieb ist, berechnet wird, und
   das Verfahren zur Erfassung einer elektrischen Leckage ferner aufweist:

   eine zweite Bestimmung eines Bestimmens, welche(r) von der elektrischen Vorrichtung oder einem auf einer elektrischen Vorrichtungsseite befindlichen Bereich (A2) ohne die elektrische Vorrichtung (20) die elektrische Leckage verursacht, basierend auf dem Wert des auf der Vorrichtungsseite befindlichen ersten elektrischen Leckagewiderstands $R_{V1}$, wenn bei der ersten Bestimmung bestimmt wird, dass sich die elektrische Leckage in dem auf der elektrischen Vorrichtungsseite befindlichen Bereich (A2) ereignet,
   bei der zweiten Bestimmung, der Wert des auf der Vorrichtungsseite befindlichen ersten elektrischen Leckagewiderstands $R_{V1}$ mit einem dritten Schwellwert $D_3$ verglichen wird, bestimmt wird, dass sich eine elektrische Leckage in der elektrischen Vorrichtung (20) ereignet, wenn der auf der Vorrichtungsseite befindliche erste elektrische Leckagewiderstand $R_{V1}$ größer oder gleich dem dritten Schwellwert $D_3$ ist, und bestimmt wird, dass sich eine elektrische Leckage in dem auf der elektrischen Vorrichtungsseite befindlichen Bereich (A2) ohne die elektrische Vorrichtung (20) ereignet, wenn der Wert des auf der Vorrichtungsseite befindlichen ersten elektrischen Leckagewiderstands $R_{V1}$ kleiner ist als der dritte

Schwellwert $D_3$, und

das Verfahren zur Erfassung einer elektrischen Leckage ferner eine vierte Erfassung eines Erfassens von einem Wert von einem auf einer positiven Elektrodenseite befindlichen elektrischen Leckagewiderstand $R_{LP}$ aufweist, welcher ein elektrische Leckagewiderstand von einem elektrisch leitfähigen Weg (30) für eine positive Elektrode ist, und von einem Wert von einem auf einer negativen Elektrodenseite befindlichen elektrischen Leckagewiderstand $R_{LN}$, welcher ein elektrischer Leckagewiderstand von einem elektrisch leitfähigen Weg (40) für eine negative Elektrode ist, wobei

das Verfahren zur Erfassung einer elektrischen Leckage ferner eine elektrische Leckagenereignungs-Positionsbestimmung eines Bestimmens einer Ereignungsposition einer elektrischen Leckage in dem auf der elektrischen Vorrichtungsseite befindlichen Bereich (A2) ohne die elektrische Vorrichtung (20) aufweist, basierend auf den Werten des auf der positiven Elektrodenseite befindlichen elektrischen Leckagewiderstands $R_{LP}$ und des auf der negativen Elektrodenseite befindlichen elektrischen Leistungswiderstands $R_{LN}$, wenn bei der zweiten Bestimmung bestimmt wird, dass sich die elektrische Leckage in dem auf der elektrischen Vorrichtungsseite befindlichen Bereich (A2) ohne die elektrische Vorrichtung (20) ereignet,

bei der vierten Bestimmung, entweder der Schaltschütz (32) für die positiven Seite oder der Schaltschütz (42) für die negative Seite EIN-geschaltet wird.

2. Verfahren zur Erfassung einer elektrischen Leckage nach Anspruch 1, wobei die erste Bestimmung aufweist:

eine vollständige Bestimmung eines Vergleichens des Werts des elektrischen Leckagewiderstands $R_Z$ des Systems mit einem ersten Schwellwert $D_1$, eines Bestimmens, dass sich keine elektrische Leckage in dem gesamten Elektrizitätsverteilungssystem (100) ereignet, wenn der Wert des elektrischen Leckagewiderstands $R_Z$ des Systems größer oder gleich dem ersten Schwellwert $D_1$ ist, und eines Bestimmens, dass sich eine elektrische Leckage in dem Elektrizitätsverteilungssystem (100) ereignet, wenn der Wert des elektrischen Leckagewiderstands $R_Z$ des Systems kleiner ist als der erste Schwellwert $D_1$; und

Bereichsbestimmung eines Vergleichens des Werts des auf der Leistungsquellenseite befindlichen elektrischen Leckagewiderstands $R_L$ mit einem zweiten Schwellwert $D_2$, wenn bei der vollständigen Bestimmung bestimmt wird, dass sich die elektrische Leckage in dem Elektrizitätsverteilungssystem (100) ereignet, eines Bestimmens, dass sich die elektrische Leckage in dem auf der elektrischen Vorrichtungsseite befindlichen Bereich (A2) ereignet, wenn der Wert des auf der Leistungsquellenseite befindlichen elektrischen Leistungswiderstands $R_L$ größer oder gleich dem zweiten Schwellwert $D_2$ ist, und eines Bestimmens, dass sich die elektrische Leckage in dem auf der Leistungsquelleneinheitsseite befindlichen Bereich ($A_1$) ereignet, wenn der auf der Leistungsquellenseite befindliche elektrische Leckagewiderstand $R_L$ kleiner ist als der zweite Schwellwert $D_2$.

3. Verfahren zur Erfassung einer elektrischen Leckage nach Anspruch 2, wobei

das Verfahren bei der ersten Bestimmung beinhaltet, dass ein absoluter Wert $|R_Z - R_L|$ einer Differenz zwischen dem Wert des elektrischen Leckagewiderstands $R_Z$ des Systems und des auf der Leistungsquellenseite befindlichen elektrischen Leckagewiderstands $R_L$ berechnet wird, der absolute Wert $|R_Z - R_L|$ der Differenz mit einem vierten Schwellwert verglichen wird, bestimmt wird, dass sich eine elektrische Leckage in dem auf der elektrischen Vorrichtungsseite befindlichen Bereich (A2) ereignet, wenn der absolute Wert $|R_Z - R_L|$ der Differenz größer oder gleich dem vierten Schwellwert ist, und bestimmt wird, dass sich eine elektrische Leckage in dem auf der Leistungsquelleneinheitsseite befindlichen Bereich (A1) ereignet, wenn der Wert des absoluten Werts $|R_Z - R_L|$ der Differenz kleiner ist als der vierte Schwellwert $D_4$.

4. Verfahren zur Erfassung einer elektrischen Leckage nach einem der Ansprüche 1 bis 3, wobei das Elektrizitätsverteilungssystem (100) beinhaltet:

eine Erfassungseinheit (60) einer Differenz eines elektrischen Referenzpotentials, welche dafür eingerichtet ist, eine Differenz $V_S$ eine elektrischen Referenzpotentials zu erfassen, welche eine Differenz eines elektrischen Potentials zwischen einem ersten Anschluss (12), welcher mit einer vorbestimmten Position der Leistungsquelleneinheit (10) verbunden ist, und einem zweiten Anschluss (14) ist, welcher mit einer Position mit einem von dem ersten Anschluss (12) unterschiedlichen elektrischen Potential verbunden ist; und

eine elektrische Leckagespannungs-Erfassungseinheit, welche mit dem ersten Anschluss (12) und dem zweiten Anschluss (14) verbunden ist und an ihrem mittleren Punkt (51) an Masse gelegt ist,

wobei die elektrische Leckagespannungs-Erfassungseinheit folgende Merkmale aufweist:

einen ersten Schalter (52), welcher mit einer Seite des ersten Anschlusses (12) verbunden ist;

einen ersten Spannungserfassungswiderstand, welcher zwischen dem ersten Schalter (52) und dem mittleren Punkt (51) bereitgestellt ist;
einen zweiten Schalter (53), welcher mit einer Seite des zweiten Anschlusses (14) verbunden ist; und
einen zweiten Spannungserfassungswiderstand, welcher zwischen dem zweiten Schalter (53) und dem mittleren Punkt (51) bereitgestellt ist.

5. Verfahren zur Erfassung einer elektrischen Leckage nach Anspruch 4, wobei

bei der vierten Erfassung, der Wert des auf der positiven Elektrodenseite befindlichen elektrischen Leckagewiderstands $R_{LP}$ basierend auf der nachstehenden Gleichung (2) berechnet wird, und der Wert des auf der negativen Elektrodenseite befindlichen elektrischen Leckagewiderstands $R_{LN}$ basierend auf der nachstehenden Gleichung (3) berechnet wird,

$$R_{LP} = \left[1 + \frac{V_g(t_1)}{V_g(t_2)} \cdot \frac{V_S(t_2)}{V_S(t_1)}\right] \cdot R_Z \quad (2)$$

[Math. 3]

$$R_{LN} = \left[1 + \frac{V_g(t_2)}{V_g(t_1)} \cdot \frac{V_S(t_1)}{V_S(t_2)}\right] \cdot R_Z \quad (3)$$

vorausgesetzt, dass in den Gleichungen (2) und (3) "$V_{g(t1)}$" eine erste Massespannung $V_{g(t1)}$ darstellt, welche durch die elektrische Leckagespannungs-Erfassungseinheit zu einem ersten Zeitpunkt t1 erfasst wird, wenn der erste Schalter (52) EIN-geschaltet wird und der zweite Schalter (53) AUS-geschaltet wird, wobei entweder der Schaltschütz (32) der positiven Seite oder der Schaltschütz (42) der negativen Seite EIN-geschaltet wird, "Vs (t1)" eine erste Differenz Vs (t1) eines elektrischen Referenzpotentials darstellt, welche durch die Erfassungseinheit (60) einer Differenz eines elektrischen Referenzpotentials zu einem ersten Zeitpunkt t1 erfasst wird, "Vg (t2)" eine zweite Massespannung Vg (t2) darstellt, welche durch die elektrische Leckagespannungs-Erfassungseinheit zu einem zweiten Zeitpunkt t2 erfasst wird, wenn der erste Schalter (52) AUS-geschaltet wird und der zweite Schalter (53) EIN-geschaltet wird, wobei entweder der Schaltschütz (32) der positiven Seite oder der Schaltschütz (42) der negativen Seite EIN-geschaltet wird, und "Vs (t2)" eine zweite Differenz Vs (t2) eines elektrischen Referenzpotentials darstellt, welche durch die Erfassungseinheit (60) einer Differenz eines elektrischen Referenzpotentials zu dem zweiten Zeitpunkt t2 erfasst wird.

6. Verfahren zur Erfassung einer elektrischen Leckage nach einem der Ansprüche 1 bis 5, ferner aufweisend:

eine fünfte Erfassung eines Ermittelns einer Differenz Vs eines elektrischen Referenzpotentials, welche eine Differenz eines elektrischen Potentials zwischen dem ersten Anschluss (12), welcher mit einer vorbestimmten Position der Leistungsquelleneinheit (10) verbunden ist, und dem zweiten Anschluss (14) ist, welcher mit einem Abschnitt mit einem von dem ersten Anschluss (12) unterschiedlichen elektrischen Potential verbunden ist, wenn in der ersten Bestimmung bestimmt wird, dass sich eine elektrische Leckage in dem auf der Leistungsquelleneinheitsseite befindlichen Bereich (A1) ereignet;
eine sechste Erfassung eines Berechnens einer auf der Leistungsquellenseite befindlichen elektrischen Leckagespannung $V_L$, welche eine Differenz eines elektrischen Potentials zwischen dem Referenzanschluss und der elektrischen Leckagenereignungs-Position mit entweder dem ersten Anschluss (12) oder dem zweiten Anschluss (14) als ein Referenzanschluss ist; und
eine siebte Erfassung eines Erfassens eines Abstands von dem Referenzanschluss zu der elektrischen Leckagenereignungs-Position basierend auf dem Verhältnis ($V_L/V_S$) der auf der Leistungsquellenseite befindlichen elektrischen Leckagespannung $V_L$ zu der Differenz $V_S$ des elektrischen Referenzpotentials, wobei
die Leistungsquelleneinheit (10) mehrere Leistungsquellen (11A bis 11N) beinhaltet.

**Revendications**

1. Procédé de détection de fuite électrique destiné à détecter une position d'apparition d'une fuite électrique dans un système de distribution d'électricité (100) dans lequel une unité de source d'alimentation (10) et un dispositif électrique (20) sont connectés électriquement l'un à l'autre,

le système de distribution d'électricité (100) comprenant:

un chemin électroconducteur d'électrode positive (30) qui connecte entre une électrode positive de l'unité de source d'alimentation (10) et le dispositif électrique (20);
un chemin électroconducteur d'électrode négative (40) qui connecte entre une électrode négative de l'unité de source d'alimentation (10) et le dispositif électrique (20);
un contacteur côté positif (32) attaché au chemin électroconducteur d'électrode positive (30) et configuré pour commuter l'état de connexion ON/OFF entre l'unité de source d'alimentation (10) et le dispositif électrique (20); et
un contacteur côté négatif (42) attaché au chemin électroconducteur d'électrode négative (40) et configuré pour commuter l'état de connexion ON/OFF entre l'unité de source d'alimentation (10) et le dispositif électrique (20);

le procédé de détection de fuite électrique comprenant:

une première détection consistant à mettre au moins l'un du contacteur côté positif (32) ou du contacteur côté négatif (42) en état ON et à détecter une valeur d'une résistance de fuite électrique du système $R_Z$ qui est une résistance de fuite électrique de l'ensemble du système de distribution d'électricité (100);
une deuxième détection consistant à mettre les deux contacteurs côté positif (32) et côté négatif (42) en état OFF et à détecter une valeur d'une résistance de fuite électrique côté source d'alimentation $R_L$ qui est une résistance de fuite électrique du côté de l'unité de source d'alimentation (10); et
une première détermination consistant à déterminer laquelle de la région côté unité de source d'alimentation ($A_1$) ou de la région côté dispositif électrique ($A_2$) cause la fuite électrique sur la base des valeurs de la résistance de fuite électrique du système $R_Z$ et de la résistance de fuite électrique côté source d'alimentation $R_L$;
dans lequel le procédé de détection de fuite électrique comprend en outre:

une troisième détection consistant à calculer une valeur d'une résistance de fuite électrique côté dispositif $R_V$ qui est une résistance de fuite électrique dans le dispositif électrique, sur la base de l'équation suivante (1);

$$Rv = \frac{Rz \cdot RL}{RL - Rz} \qquad (1)$$

dans la troisième détection, une valeur d'une première résistance de fuite électrique côté dispositif $R_{V1}$ qui est une résistance de fuite électrique côté dispositif $R_V$ lorsque le dispositif électrique est à l'arrêt est calculée; et
le procédé de détection de fuite électrique comprend en outre:

une deuxième détermination consistant à déterminer lequel du dispositif électrique ou d'une région côté dispositif électrique ($A_2$) excluant le dispositif électrique (20) cause la fuite électrique sur la base de la valeur de la première résistance de fuite électrique côté dispositif $R_{V1}$ si la fuite électrique est déterminée comme étant dans la région côté dispositif électrique ($A_2$) dans la première détermination;
dans la deuxième détermination, la valeur de la première résistance de fuite électrique côté dispositif $R_{V1}$ est comparée avec une troisième valeur seuil $D_3$, il est déterminé qu'une fuite électrique se produit dans le dispositif électrique (20) si la première résistance de fuite électrique côté dispositif $R_{V1}$ est supérieure ou égale à la troisième valeur seuil $D_3$, et il est déterminé qu'une fuite électrique se produit dans la région côté dispositif électrique ($A_2$) excluant le dispositif électrique (20) si la valeur de la première résistance de fuite électrique côté dispositif $R_{V1}$ est inférieure à la troisième valeur seuil $D_3$; et
le procédé de détection de fuite électrique comprend en outre:

une quatrième détection de détection d'une valeur d'une résistance de fuite électrique côté électrode positive $R_{LP}$ qui est une résistance de fuite électrique d'un chemin électroconducteur d'électrode positive (30) et d'une valeur d'une résistance de fuite électrique côté électrode négative $R_{LN}$ qui est une résistance de fuite électrique d'un chemin électroconducteur d'électrode négative (40);

dans lequel le procédé de détection de fuite électrique comprend en outre:

une détermination de la position d'apparition de la fuite électrique consistant à déterminer une position d'apparition d'une fuite électrique dans la région côté dispositif électrique ($A_2$) excluant le dispositif électrique (20), sur la base des valeurs de la résistance de fuite électrique côté électrode positive $R_{LP}$ et de la résistance de fuite électrique côté électrode négative $R_{LN}$ si la fuite électrique est déterminée comme se produisant dans la région côté dispositif électrique ($A_2$) excluant le dispositif électrique (20) dans la deuxième détermination, et

dans la quatrième détection, au moins l'un du contacteur côté positif (32) et du contacteur côté négatif (42) est mis en état ON.

2. Procédé de détection de fuite électrique selon la revendication 1, dans lequel la première détermination comprend:

une détermination entière consistant à comparer la valeur de la résistance de fuite électrique du système $R_Z$ avec une première valeur seuil $D_1$, à déterminer qu'une fuite électrique ne se produit pas dans l'ensemble du système de distribution d'électricité (100) si la valeur de la résistance de fuite électrique du système $R_Z$ est supérieure ou égale à la première valeur seuil $D_1$, et à déterminer qu'une fuite électrique se produit dans le système de distribution d'électricité (100) si la valeur de la résistance de fuite électrique du système $R_Z$ est inférieure à la première valeur seuil $D_1$; et

une détermination de région consistant à comparer la valeur de la résistance de fuite électrique côté source d'alimentation $R_L$ avec une deuxième valeur seuil $D_2$ si la fuite électrique est déterminée comme se produisant dans le système de distribution d'électricité (100) dans la détermination entière, à déterminer que la fuite électrique se produit dans la région côté dispositif électrique ($A_2$) si la valeur de la résistance de fuite électrique côté source d'alimentation $R_L$ est supérieure ou égale à la deuxième valeur seuil $D_2$, et à déterminer que la fuite électrique se produit dans la région côté unité de source d'alimentation ($A_1$) si la résistance de fuite électrique côté source d'alimentation $R_L$ est inférieure à la deuxième valeur seuil $D_2$.

3. Procédé de détection de fuite électrique selon la revendication 2, dans lequel
dans la première détermination, une valeur absolue $|R_Z - R_L|$ de la différence entre les valeurs de la résistance de fuite électrique du système $R_Z$ et de la résistance de fuite électrique côté source d'alimentation $R_L$ est calculée, la valeur absolue $|R_Z - R_L|$ de la différence est comparée avec une quatrième valeur seuil $D_4$, il est déterminé qu'une fuite électrique se produit dans la région côté dispositif électrique ($A_2$) si la valeur absolue $|R_Z - R_L|$ de la différence est supérieure ou égale à la quatrième valeur seuil $D_4$, et il est déterminé qu'une fuite électrique se produit dans la région côté unité de source d'alimentation ($A_1$) si la valeur de la valeur absolue $|R_Z - R_L|$ de la différence est inférieure à la quatrième valeur seuil $D_4$.

4. Procédé de détection de fuite électrique selon l'une quelconque des revendications 1 à 3, dans lequel
le système de distribution d'électricité (100) comprend:

une unité de détection de différence de potentiel de référence (60) configurée pour détecter une différence de potentiel de référence $V_S$ qui est une différence de potentiel électrique entre une première borne (12) connectée à une position prédéterminée de l'unité de source d'alimentation (10) et une deuxième borne (14) connectée à une portion ayant un potentiel électrique différent de celui de la première borne (12); et
une unité de détection de tension de fuite électrique connectée à la première borne (12) et à la deuxième borne (14) et connectée à la terre à son point médian (51),
l'unité de détection de tension de fuite électrique comprenant:

un premier interrupteur (52) connecté au côté de la première borne (12), une première résistance de détection de tension disposée entre le premier interrupteur (52) et le point médian (51),
un second interrupteur (53) connecté au côté de la deuxième borne (14), et
une deuxième résistance de détection de tension disposée entre le second interrupteur (53) et le point médian (51).

**5.** Procédé de détection de fuite électrique selon la revendication 4, dans lequel

dans la quatrième détection, la valeur de la résistance de fuite électrique côté électrode positive $R_{LP}$ est calculée sur la base de l'équation suivante (2), et la valeur de la résistance de fuite électrique côté électrode négative $R_{LN}$ est calculée sur la base de l'équation suivante (3),

$$R_{LP} = \left[ 1 + \frac{V_g(t_1)}{V_g(t_2)} \cdot \frac{V_S(t_2)}{V_S(t_1)} \right] \cdot R_Z \qquad (2)$$

$$R_{LN} = \left[ 1 + \frac{V_g(t_2)}{V_g(t_1)} \cdot \frac{V_S(t_1)}{V_S(t_2)} \right] \cdot R_Z \qquad (3)$$

étant donné que dans les équations (2) et (3), "$V_g(t_1)$" représente une première tension de fuite électrique à la terre $V_g(t_1)$ détectée par l'unité de détection de tension de fuite électrique à un premier temps t1 lorsque le premier interrupteur (52) est fermé et le second interrupteur (53) est ouvert avec au moins l'un des contacteurs côté positif (32) ou côté négatif (42) fermé, "$V_S(t_1)$" représente une première différence de potentiel de référence $V_S(t_1)$ détectée par l'unité de détection de différence de potentiel de référence (60) au premier temps $t_1$, "$V_g(t_2)$" représente une deuxième tension de fuite à la terre $V_g(t_2)$ détectée par l'unité de détection de tension de fuite électrique à un deuxième temps $t_2$ lorsque le premier interrupteur (52) est ouvert et le second interrupteur (53) est fermé avec au moins l'un des contacteurs (32 ou 42) fermé, et "$V_S(t_2)$" représente une deuxième différence de potentiel de référence $V_S(t_2)$ détectée au deuxième temps $t_2$ par l'unité de détection de différence de potentiel de référence (60).

**6.** Procédé de détection de fuite électrique selon l'une quelconque des revendications 1 à 5, comprenant en outre:

une cinquième détection consistant à obtenir une différence de potentiel de référence $V_S$ qui est une différence de potentiel entre la première borne (12) connectée à une position prédéterminée de l'unité de source d'alimentation (10) et la deuxième borne (14) connectée à une portion avec un potentiel électrique différent de celui de la première borne (12) s'il est déterminé qu'une fuite électrique se produit dans la région côté unité de source d'alimentation (A1) dans la première détermination;
une sixième détection consistant à calculer une tension de fuite électrique côté source d'alimentation $V_L$ qui est une différence de potentiel électrique entre la borne de référence et la position d'apparition de la fuite électrique avec l'une quelconque de la première borne (12) ou de la deuxième borne (14) utilisée comme borne de référence; et
une septième détection consistant à détecter une distance depuis la borne de référence jusqu'à la position d'apparition de la fuite électrique sur la base du rapport ($V_L/V_S$) entre la tension de fuite électrique côté source d'alimentation $V_L$ et la différence de potentiel de référence $V_S$, et
dans lequel l'unité de source d'alimentation (10) comprend de multiples sources d'alimentation (11A à 11N).

FIG.1

EP 4 191 266 B1

START

S10 — DETECT $R_Z$

$R_Z \geqq D_1$?  —  Yes →

S32

S30

No

DETECT $R_L$  —  S20

S34

$R_L \geqq D_2$?  —  No →

Yes

S40(S42) — DETECT $R_{V1}$

S90 — DETECT $V_S$

No

$R_{V1} \geqq D_3$?

S50

Yes

S100 — DETECT $V_L$

S60 — DETECT $R_{LP} \cdot R_{LN}$

S110 — CALCULATE $V_L/V_S$

S70 — DETECT ELECTRICAL LEAKAGE OCCURRING POSITION

S80 — NOTIFY OF ELECTRICAL LEAKAGE OCCURRING POSITION

END

FIG.2

28

FIG.3

START

S10 — DETECT $R_Z$

S40(S42) — DETECT $R_{V1}$

S60 — DETECT $R_{LP} \cdot R_{LN}$

$R_Z \geqq D_1$? — No

S32

S30

Yes

DETECT $R_L$ — S20

S34

$R_L \geqq D_2$? — No

Yes

S90 — DETECT $V_S$

Yes — $R_{V1} \geqq D_3$?

S50

No

S100 — DETECT $V_L$

S70 — DETECT ELECTRIC LEAKAGE OCCURRING POSITION

10 — CALCULATE $V_L/V_S$

S80 — NOTIFY OF ELECTRIC LEAKAGE OCCURRING POSITION

END

FIG.4

FIG.5

FIG.6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016091551 A1
- JP 2007327856 A
- JP 2007149561 A
- WO 2020170556 A